(19) **Europäisches Patentamt / European Patent Office / Office européen des brevets**

(11) **EP 2 563 099 B1**

(12) # EUROPEAN PATENT SPECIFICATION

(45) Date of publication and mention
of the grant of the patent:
**22.03.2017 Bulletin 2017/12**

(21) Application number: **11762629.1**

(22) Date of filing: **22.03.2011**

(51) Int Cl.:
***H05G 2/00*** *(2006.01)*

(86) International application number:
**PCT/JP2011/056820**

(87) International publication number:
**WO 2011/122397 (06.10.2011 Gazette 2011/40)**

(54) **EXTREME ULTRAVIOLET LIGHT GENERATOR**

GENERATOR FÜR EXTREM ULTRAVIOLETTES LICHT

GÉNÉRATEUR DE LUMIÈRE DE L'EXTRÊME ULTRAVIOLET

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.03.2011   JP 2011058026
27.01.2011   JP 2011015695
29.11.2010   JP 2010265791
29.03.2010   JP 2010074256**

(43) Date of publication of application:
**27.02.2013   Bulletin 2013/09**

(73) Proprietor: **Gigaphoton Inc.
Tochigi 323-8558 (JP)**

(72) Inventors:
• **WAKABAYASHI Osamu
Hiratsuka-shi
Kanagawa 254-0014 (JP)**

• **YANAGIDA Tatsuya
Hiratsuka-shi
Kanagawa 254-0014 (JP)**

(74) Representative: **Global IP Europe
Patentanwaltskanzlei
Pfarrstraße 14
80538 München (DE)**

(56) References cited:
**EP-A2- 1 589 792      WO-A1-2006/075535
WO-A2-2005/025280      JP-A- 10 221 499
JP-A- 2003 270 551      JP-A- 2003 272 892
JP-A- 2005 235 959      JP-A- 2007 505 460
JP-A- 2008 103 151      US-A1- 2006 215 712**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

This disclosure relates to an extreme ultraviolet (EUV) light generating apparatus which generates extreme ultraviolet light.

Background Art

In recent years, as semiconductor processes become finer, finer fabrication in photolithography has been making rapid progress. In the next generation, microfabrication at 60 nm to 45 nm, and further, microfabrication at 32 nm or less will be required. Accordingly, in order to meet the demand for microfabrication at 32 nm or less, for example, an exposure apparatus is expected to be developed, in which an EUV light generating apparatus which generates EUV light at a wavelength of approximately 13 nm is combined with a reduced projection reflective optical system.

There are three kinds of apparatuses for generating EUV light, which include an laser produced plasma (LPP) type apparatus in which plasma generated by irradiating a target with a laser beam is used, a discharge produced plasma (DPP) type apparatus in which plasma generated by electric discharge is used, and a synchrotron radiation (SR) type apparatus in which orbital radiation light is used.

EP 1 589 792 A2 discloses a chamber device that is used with at least one laser beam generating device, comprising a chamber provided with at least one incident port for introducing at least one laser beam, the laser beam being emitted from the at least one laser beam generating device, to an inside thereof; a target supply unit provided to the chamber and supplies a target material to a predetermined region in the chamber; a laser focusing optical system configured to focus the at least one laser beam in the predetermined region; and an optical element configured to correct light intensity distribution of a beam section, in the predetermined region, of the at least one laser beam, wherein the optical element is configured to correct the light intensity distribution so that the light intensity distribution of the beam section, in the predetermined region, of the at least one laser beam has predetermined evenness in the predetermined region of the beam section.

WO 2005/025280 A2 discloses a method of producing extreme ultraviolet radiation (EUV) or soft X-ray radiation by means of an electrical operated discharge, in particular for EUV lithography or for metrology, in which a plasma is ignited in a gaseous medium between at least two electrodes in a discharge space, said plasma emitting said radiation that is to be produced, wherein said gaseous medium is produced from a metal melt, which is applied to a surface in said discharge space and at least partially evaporated by an energy beam, in particular by a laser beam.

US 2006/215712 A1 discloses that an expanded target is acted upon by at least a second prepulse which is adapted to a target diameter Dv that is increased due to the reduced target density, and an initial ionization is generated by simple photon ionization or multiphoton ionization.

SUMMARY

A chamber device according to one aspect of the present disclosure is defined in the independent claims.

BRIEF DESCRIPTION OF THE DRAWINGS

Fig. 1A is a diagram illustrating a technical problem example in the present disclosure;
Fig. 1B is a diagram illustrating a technical problem example in the present disclosure;
Fig. 1C is a diagram illustrating a technical problem example in the present disclosure;
Fig. 2A is a diagram illustrating one example of a behavior of a target material when a droplet is irradiated with a pre-pulse laser beam, in the present disclosure;
Fig. 2B is a diagram illustrating one example of a behavior of a target material when a droplet is irradiated with a pre-pulse laser beam, in the present disclosure;
Fig. 2C is a diagram illustrating one example of a behavior of a target material when a droplet is irradiated with a pre-pulse laser beam, in the present disclosure;
Fig. 3A is a diagram illustrating another example of a behavior of a target material when a droplet is irradiated with a pre-pulse laser beam, in the present disclosure;
Fig. 3B is a diagram illustrating another example of a behavior of a target material when a droplet is irradiated with a pre-pulse laser beam, in the present disclosure;

Fig. 3C is a diagram illustrating another example of a behavior of a target material when a droplet is irradiated with a pre-pulse laser beam, in the present disclosure;

Fig. 4A is a diagram illustrating a relationship between a droplet diameter and a beam diameter, which is viewed from a beam axis direction, in the present disclosure;

Fig. 4B is a diagram illustrating a relationship between a droplet diameter and a beam diameter, which is viewed from a beam axis direction, in the present disclosure;

Fig. 5 is a table illustrating a setting example of a value of $\Delta X$ on variation of a droplet in the present disclosure;

Fig. 6 is a diagram illustrating a relationship between a variation direction of a position of a droplet and a beam diameter, which is viewed from an axial direction of a beam, in the present disclosure;

Fig. 7A is a diagram illustrating an example of light intensity distribution of a pre-pulse laser beam in the present disclosure;

Fig. 7B is a diagram illustrating an example of light intensity distribution of a pre-pulse laser beam in the present disclosure;

Fig. 7C is a diagram illustrating an example of light intensity distribution of a pre-pulse laser beam in the present disclosure;

Fig. 8 is a diagram illustrating light intensity distribution of a laser beam with which a target material is irradiated;

Fig. 9 is a diagram illustrating the schematic configuration of an EUV light generating apparatus according to a first embodiment;

Fig. 10 is a conceptual diagram illustrating an example on a correcting optical element;

Fig. 11 is a conceptual diagram illustrating another example on a correcting optical element;

Fig. 12 is a conceptual diagram illustrating still another example on a correcting optical element;

Fig. 13 is a conceptual diagram illustrating yet another example on a correcting optical element;

Fig. 14 is a diagram illustrating the schematic configuration of an EUV light generating apparatus according to a second embodiment;

Fig. 15A is a diagram illustrating the schematic configuration of an EUV light generating apparatus according to a third embodiment;

Fig. 15B is a sectional view taken along an XVB-XVB line of the EUV light generating apparatus depicted in Fig. 15A;

Fig. 16 is a diagram illustrating the schematic configuration of an EUV light generating apparatus according to a fourth embodiment;

Fig. 17A is a diagram illustrating the schematic configuration of an EUV light generating apparatus according to a fifth embodiment;

Fig. 17B is a sectional view taken along an XVIIB-XVIIB line of the EUV light generating apparatus depicted in Fig. 17A;

Fig. 18 is a diagram illustrating the schematic configuration of an EUV light generating apparatus according to a sixth embodiment;

Fig. 19A is a conceptual diagram illustrating a state where a droplet is irradiated with a pre-pulse laser beam;

Fig. 19B is a conceptual diagram illustrating a state where a torus-shaped diffused target which is formed by irradiating a droplet with a pre-pulse laser beam is irradiated with a main-pulse laser beam having top hat type light intensity distribution;

Fig. 19C is a conceptual diagram illustrating a state where a torus-shaped diffused target which is formed by irradiating a droplet with a pre-pulse laser beam is irradiated with a main-pulse laser beam having top hat type light intensity distribution;

Fig. 20 is a conceptual diagram illustrating a configuration example of a titanium sapphire laser which generates a pre-pulse laser beam in an EUV light generating apparatus according to a seventh embodiment;

Fig. 21 is a conceptual diagram illustrating a configuration example of a fiber laser which generates a pre-pulse laser beam in an EUV light generating apparatus according to an eighth embodiment;

Fig. 22 is a table illustrating an example of an irradiation condition of a pre-pulse laser beam in the present disclosure;

Fig. 23 is a diagram illustrating the schematic configuration of an EUV light generating apparatus according to a ninth embodiment; and

Fig. 24 is a diagram illustrating the schematic configuration of an EUV light generating apparatus according to a tenth embodiment.

EMBODIMENTS

Several embodiments will be described in detail below as mere examples with reference to the accompanying drawings. The embodiments described below are merely illustrative in nature and do not limit the scope of the present disclosure. Further, the configurations described in connection with the embodiments below are not necessarily essential in implementation of the configurations in the present disclosure. Like elements are referenced by like referential symbols and duplicate descriptions thereof will be omitted.

<1. Background of Embodiments>

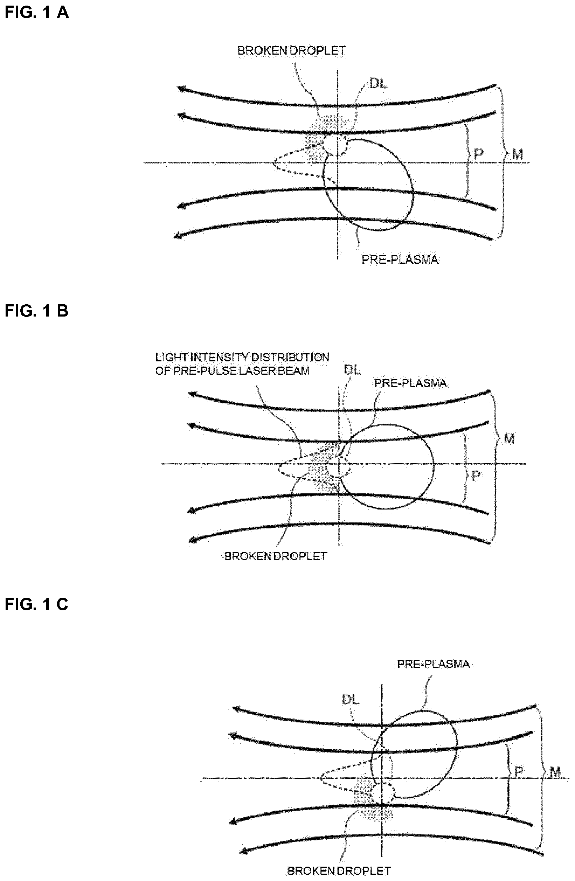

Figs. 1A to 1C are diagrams illustrating a technical problem example in the present disclosure. This technical problem example has newly arisen in a method in which a metal droplet which is a primary target is irradiated with a pre-pulse laser beam to generate a secondary target and this secondary target is irradiated with a main-pulse laser beam.

Figs. 1A to 1C illustrate an example of a behavior of a target material when a droplet DL which is the target material is irradiated with a pre-pulse laser beam P. As illustrated in Fig. 1B, it is preferable that the pre-pulse laser beam P be directed toward an intersection of dashed-dotted lines in the drawing when the droplet DL reaches the intersection.

Depending on conditions such as a diameter of the droplet DL and light intensity of the pre-pulse laser beam P, when the droplet DL is irradiated with the pre-pulse laser beam P, pre-plasma may be generated from a surface of the droplet DL which is irradiated with the pre-pulse laser beam P. As depicted in Fig. 1B, pre-plasma jets in an approximately opposite direction to a traveling direction of the pre-pulse laser beam P. Pre-plasma is generated such that a part around an irradiation surface with the pre-pulse laser beam P becomes vapor containing ions or neutral particles. This pre-plasma generating phenomenon is called laser ablation as well.

Further, when the droplet DL is irradiated with the pre-pulse laser beam P, the droplet DL may be broken. As illustrated in Fig. 1B, a broken droplet scatters in approximately the same direction as the traveling direction of the pre-pulse laser beam P, due to reaction force generated by jet of the pre-plasma.

Hereinafter, a target which contains either one of pre-plasma which is generated by irradiation of a droplet with a pre-pulse laser beam and a broken droplet is referred to as a diffused target.

A position of the droplet DL at a time of irradiation with the pre-pulse laser beam P is unstable, and there may be cases where the position is shifted to the upper side of the paper plane of the drawing from the intersection of the dashed-dotted lines as depicted in Fig. 1A and where the position is shifted to the lower side of the paper plane of the drawing from the intersection of the dashed-dotted lines as depicted in Fig. 1C. In one method, a droplet can be irradiated with a pre-pulse laser beam by increasing a beam diameter of the pre-pulse laser beam.

However, light intensity distribution of a laser beam emitted from a laser device commonly exhibits Gaussian distribution in which the light intensity is high at a central part of a section orthogonal to a beam axis and the light intensity decreases toward a peripheral part. In a case where the droplet DL is irradiated with such a laser beam serving as the pre-pulse laser beam P, there is a possibility where the droplet DL is irradiated with the pre-pulse laser beam P in a manner that the center of the droplet DL is positioned on a part other than the center of the Gaussian distribution as depicted in Figs. 1A and 1C, in the above-mentioned method.

In a case where the pre-pulse laser beam P is applied such that the center of the droplet DL is positioned on a part other than the center of the Gaussian distribution in the pre-pulse laser beam P, irradiation energy is disproportionately provided to a part, which is close to the center of the Gaussian distribution in the pre-pulse laser beam P, of an irradiation surface of the droplet DL. Consequently, pre-plasma jets in a direction different from the beam axis direction of the pre-pulse laser beam P. Further, the above-mentioned broken droplet scatters in a direction different from the beam axis of the pre-pulse laser beam P as well due to reaction force by jet of the pre-plasma or the like.

Thus, a diffused target which is generated by irradiation of a droplet with a pre-pulse laser beam diffuses in different directions depending on a position of the droplet in pre-pulse laser beam irradiation. Accordingly, it may become difficult to irradiate the diffused target with a main-pulse laser beam M.

<2. Overview of Embodiments>

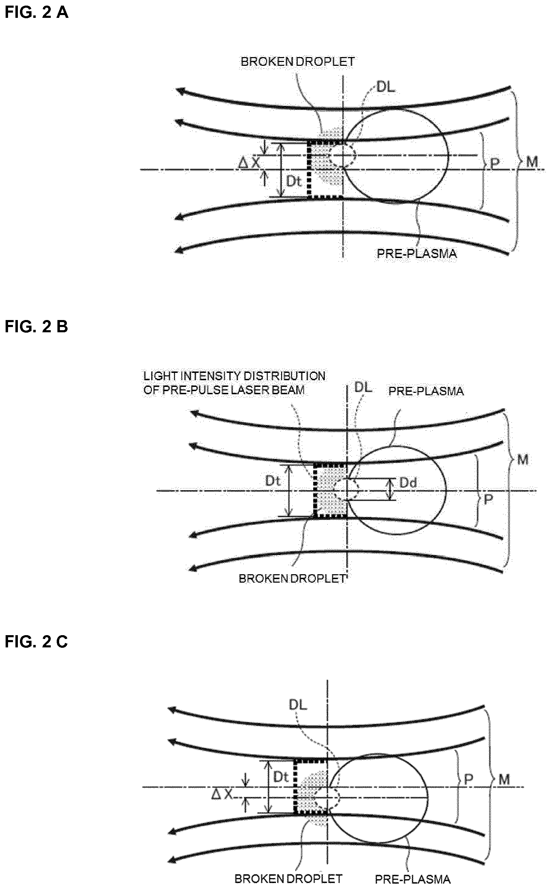

Figs. 2A to 2C illustrate an example of a behavior of a target material when a droplet is irradiated with a pre-pulse laser beam in the present disclosure. In Figs. 2A to 2C, a position of a droplet DL is unstable in irradiation with a pre-pulse laser beam P (for example, Figs. 2A and 2C) in a similar manner to the case depicted in Figs. 1A to 1C. However, in Figs. 2A to 2C, a section orthogonal to the beam axis of the pre-pulse laser beam P includes a region (diameter Dt) in which light intensity distribution has predetermined evenness.

In any of Figs. 2A to 2C, the droplet DL is positioned in the region (diameter Dt), which has the predetermined evenness in the light intensity distribution, of the pre-pulse laser beam P. Therefore, the whole of the droplet DL is irradiated with the pre-pulse laser beam P at even light intensity. Accordingly, even if a position of the droplet DL varies when the droplet DL is irradiated with the pre-pulse laser beam P, a target can be diffused in a direction along the beam axis of the pre-pulse laser beam P. Consequently, the whole of the diffused target can be irradiated with a main-pulse laser beam M.

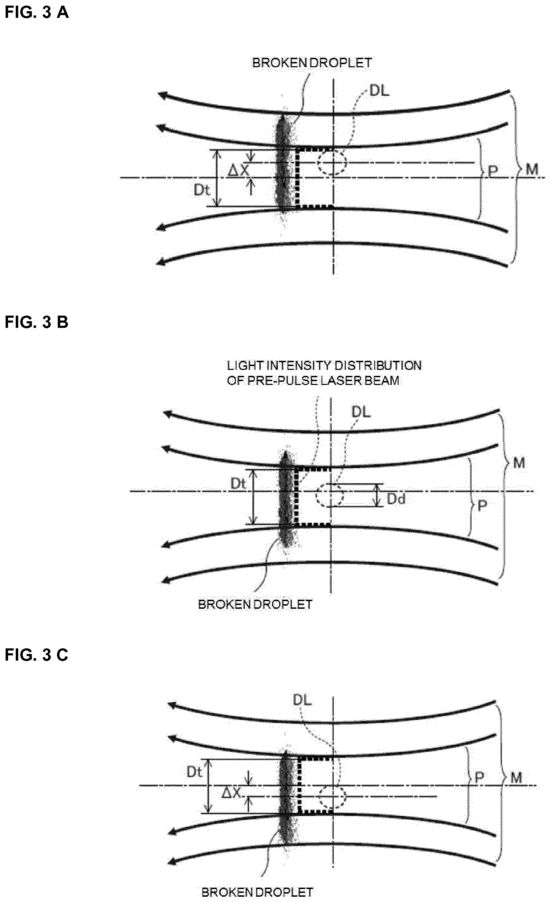

Figs. 3A to 3C illustrate another example of a behavior of a target material when a droplet is irradiated with a pre-pulse laser beam in the present disclosure. In Figs. 3A to 3C as well, a section orthogonal to the beam axis of a pre-pulse laser beam P includes a region (diameter Dt) in which light intensity distribution has predetermined evenness, in a similar manner to the case illustrated in Figs. 2A to 2C.

In Figs. 3A to 3C, the droplet DL is shattered and scattered in a disc shape so as to be a diffused target, which is different from the case of Figs. 2A to 2C. Such a behavior of the target material may be obtained when the diameter of the droplet DL is set to be approximately mass limited (approximately 10 $\mu$m) and the light intensity of the pre-pulse laser beam P is adjusted to predetermined intensity.

In Figs. 3A to 3C, even when the position of the droplet DL with respect to the pre-pulse laser beam P is unstable (for example, Figs. 3A and 3C), the droplet DL is positioned in the region (diameter Dt), which has predetermined evenness in the light intensity distribution, of the pre-pulse laser beam P. Therefore, the whole of the droplet DL is irradiated with the pre-pulse laser beam P at even light intensity. Accordingly, even if a position of the droplet DL varies, the pre-pulse laser beam P can diffuse a target material in a direction along the beam axis of the pre-pulse laser beam P. Consequently, the whole of the diffused target can be irradiated with a main-pulse laser beam M.

<3. Diameter of Region Having Predetermined Evenness>

The diameter Dt of a region, which has predetermined evenness in light intensity distribution, of a laser beam is now described with reference to Figs. 2A to 2C and Figs. 3A to 3C.

In order to diffuse a target in the beam axis direction of a pre-pulse laser beam P when a droplet DL is irradiated with the pre-pulse laser beam P, it is preferable to irradiate the whole hemisphere face of the droplet DL with a part, in which the light intensity has predetermined evenness, in a beam section. Accordingly, when a diameter of the droplet DL is denoted as Dd, it is preferable that the diameter Dt of a region, in which the light intensity distribution has predetermined evenness, of a beam section of the pre-pulse laser beam P be larger than the diameter Dd of the droplet DL.

Further, when variation of a position of the droplet DL in irradiation of the pre-pulse laser beam P is assumed, it is preferable that the assumed variation $\Delta X$ be considered. For example, it is favorable that the diameter Dt of the region, in which the light intensity distribution has predetermined evenness, of a beam section of the pre-pulse laser beam P satisfies the following condition.

$$Dt \geq Dd + 2\Delta X$$

Namely, it is preferable that the diameter Dt of the region, in which the light intensity distribution has predetermined evenness, of the beam section of the pre-pulse laser beam P be equal to or larger than a value obtained by adding the variation $\Delta X$ of the position of the droplet DL to the diameter Dd of the droplet DL. In this example, a double value of $\Delta X$ is added to the diameter Dd of the droplet DL because variation in vertical and horizontal directions when viewed in the beam axis direction is assumed.

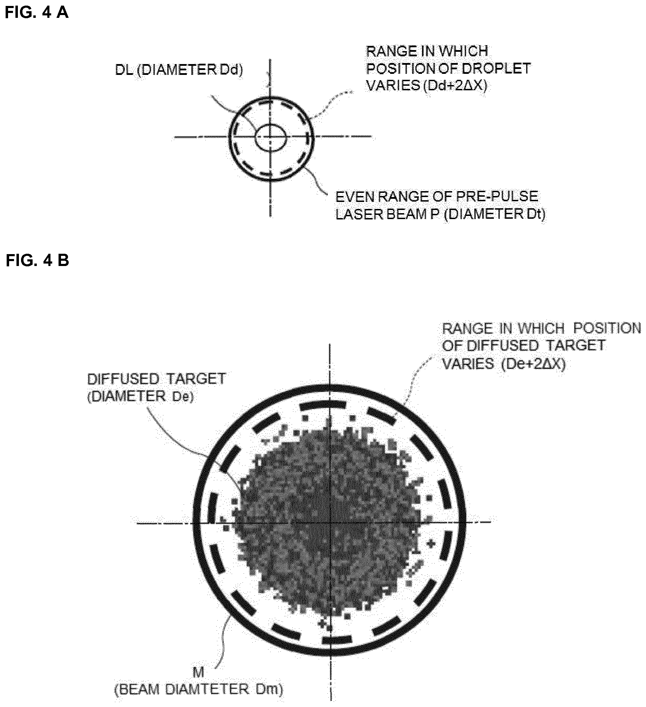

Figs. 4A and 4B are diagrams illustrating a relationship between a droplet diameter and a beam diameter, which is viewed in the beam axis direction, in the present disclosure. As depicted in Fig. 4A, it is preferable that the diameter Dt of the region, in which the light intensity distribution has predetermined evenness, of a beam section of the pre-pulse laser beam P be equal to or larger than a value obtained by adding a double value of $\Delta X$ to the diameter Dd of the droplet DL.

Next, as depicted in Fig. 4B, it is preferable that a beam diameter Dm of the main-pulse laser beam M be equal to or larger than a diameter De of a diffused target so as to irradiate the whole of the diffused target with the main-pulse laser beam M.

Further, when the region in which the light intensity distribution has predetermined evenness exists in the beam section of the pre-pulse laser beam P, the following can be said about variation of a position of a diffused target. A diffused target diffuses in the beam axis direction of the pre-pulse laser beam P. Accordingly, variation of a position of a diffused target is not caused by a diffusing direction of the diffused target. The variation of a position of a diffused target is mainly caused by variation $\Delta X$ of a position of a droplet, which is generated in irradiation with the pre-pulse laser beam P. Accordingly, it is preferable that the beam diameter Dm of the main-pulse laser beam M satisfy the following condition, for example.

$$Dm \geq De + 2\Delta X$$

That is, it is preferable that the beam diameter Dm of the main-pulse laser beam M be equal to or larger than a value obtained by adding the variation $\Delta X$ of a position of a droplet DL to the diameter De of a diffused target. In this example, a double value of $\Delta X$ is added to the diameter De of a diffused target because variation in vertical and horizontal directions when viewed in the beam axis direction is assumed.

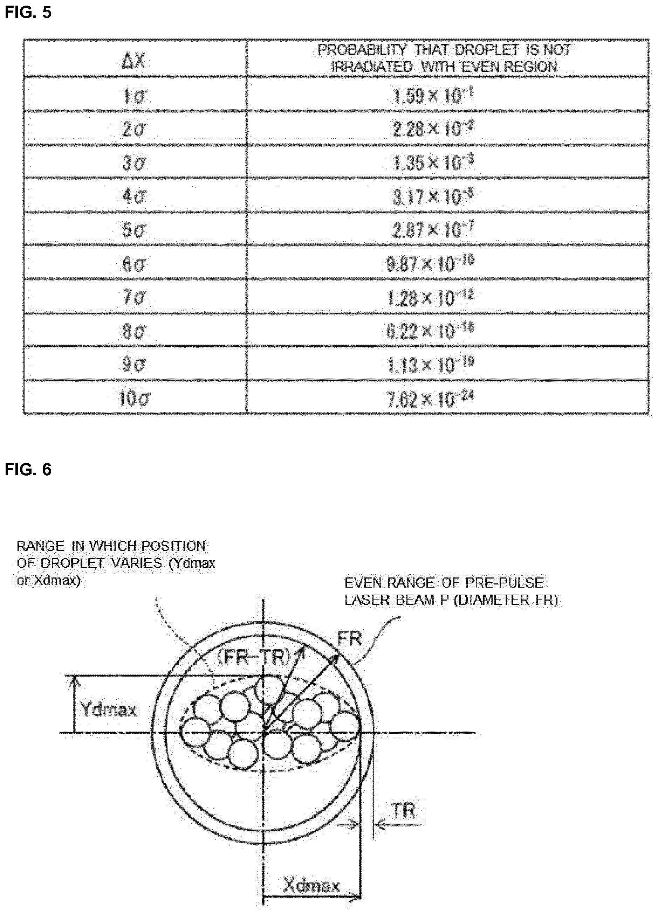

Fig. 5 is a table illustrating a setting example of a value of $\Delta X$ on variation of a position of a droplet in the present disclosure. When standard deviation of a distance between a center of a pre-pulse laser beam and a center of a droplet is denoted as σ, it can be considered that ΔX is set to σ, 2σ, 3σ, ... , for example.

Here, when it is assumed that a distance between a center of a pre-pulse laser beam and a center of a droplet follows normal distribution, probability that the droplet is irradiated (or probability that the droplet is not irradiated) with a region, in which light intensity distribution has predetermined evenness, of a beam section of the pre-pulse laser beam can be calculated under the condition of the above-mentioned Dt ≥ Dd + 2ΔX.

The right column of Fig. 5 shows probability that a droplet is not irradiated with the region Dt, in which the light intensity distribution has predetermined evenness, of the beam section of the pre-pulse laser beam P. As shown in the table, probability that a droplet is not irradiated with the region Dt having the predetermined evenness is 15.9% in a case of ΔX=σ, 2.28% in a case of ΔX=2σ, and 0.135% in a case of ΔX=3σ. It is preferable to set ΔX to have a value of 2σ or more so as to stabilize the intensity of EUV light.

Here, in the above description, the beam sections of the pre-pulse laser beam and the main-pulse laser beam have circular shapes and the sections of the droplet and the diffused target (sections orthogonal to the beam axis of the laser beam) have circular shapes. However, the present disclosure is not limited to this. For example, an area of a region, which has predetermined evenness, of a pre-pulse laser beam may be larger than the largest area of the section of a droplet. Further, the smallest value of a dimension of the region, which has predetermined evenness, of a pre-pulse laser beam may be equal to or larger than a value obtained by adding a range of variation of a position of a droplet to the largest value of a dimension of the droplet section. Further, an area of the beam section of a main-pulse laser beam may be larger than the largest area of the section of a diffused target. Further, the smallest value in a dimension of the beam section of a main-pulse laser beam may be equal to or larger than a value obtained by adding a range of variation of a position of a diffused target to the largest value in a dimension of the section of the diffused target.

Fig. 6 is a diagram illustrating a relationship between a variation direction of a position of a droplet and a beam diameter, which is viewed in a beam axis direction, in the present disclosure. As shown in Fig. 6, variation of a position of a droplet in a direction orthogonal to the beam axis of the pre-pulse laser beam P may be evaluated in a plurality of directions. In Fig. 6, a sum of the maximum value of variation of a droplet center position in an X direction (horizontal direction of the paper plane) from a center of a pre-pulse laser beam and a radius of the droplet is denoted as Xdmax, and a sum of the maximum value of variation of the droplet center position in a Y direction (vertical direction of the paper plane) from the center of the pre-pulse laser beam and the radius of the droplet is denoted as Ydmax. A case where the maximum value of variation in the X direction is larger than the maximum value of variation in the Y direction (Xdmax>Ydmax), for example, is shown.

In such a case, a dimension of a beam section of a pre-pulse laser beam P may be determined by setting the X direction, in which the variation is larger, as reference, for example. A region, in which light intensity has predetermined evenness, of a beam section of the pre-pulse laser beam P may be set to have a circular shape of which a radius has a length FR equal to or larger than Xdmax, for example. Alternatively, the region, of which the light intensity has the predetermined evenness, of the beam section of the pre-pulse laser beam P may be set to have an elliptical shape or other shape of which a dimension in the X direction (length from the center of the beam axis to an edge of the region having the predetermined evenness) is equal to or larger than Xdmax. Further, on ground that the dimension of the region, in which the light intensity has the predetermined evenness, of the beam section of the pre-pulse laser beam P may have variation TR as well, the region having the predetermined evenness may be set to have a shape of which a dimension in the X direction is equal to or larger than (Xdmax + TR).

Further, the beam diameter of the pre-pulse laser beam P may be set to be able to be changed depending on variation of a position of a droplet. When the beam diameter is changed while maintaining light energy of the pre-pulse laser beam P constant, the light intensity (light energy per unit area) on an irradiation surface of the pre-pulse laser beam P changes in inverse proportion to square of the beam diameter. Accordingly, the light energy may be adjusted so as to stabilize the light intensity. Further, the shape of the region (sectional shape of a beam), in which the light intensity has predetermined evenness, of the beam section of the pre-pulse laser beam P may be adjusted to be an elliptical shape of which a dimension in the X direction is (Xdmax+TR) and a dimension in the Y direction is (Ydmax+TR). In terms of the main-pulse laser beam as well, a dimension and a shape of a beam section may be adjusted depending on variation in the X direction and variation in the Y direction of a diffused target, for example.

<4. Example of Light Intensity Distribution>

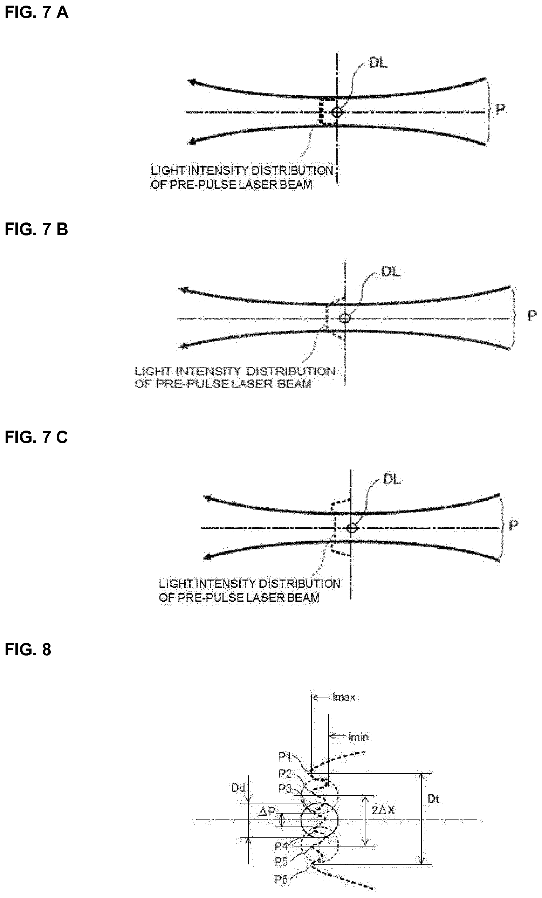

Figs. 7A to 7C are diagrams illustrating an example of light intensity distribution of a pre-pulse laser beam in the present disclosure. As illustrated in Fig. 7A, in a case where a pre-pulse laser beam P has even light intensity in the whole range of a beam section, it can be said that the light intensity distribution of the pre-pulse laser beam P is an even top hat type, that is, has evenness.

Further, as illustrated in Fig. 7B, even in a case where the pre-pulse laser beam P has a region, in which the light intensity gradually decreases, near an edge part in the beam diameter direction, it can be said that the pre-pulse laser beam P includes a region having evenness when having even light intensity around a central part which is surrounded by the edge part.

Further, as illustrated in Fig. 7C, even in a case where the pre-pulse laser beam P has a region, in which the light intensity is high, near an edge part in the beam diameter direction, it can be said that the pre-pulse laser beam P includes a region having evenness when having even light intensity around a central part which is surrounded by the edge part.

In order to diffuse a target in the beam axis direction of the pre-pulse laser beam P when a droplet DL is irradiated with the pre-pulse laser beam P, it is preferable that the pre-pulse laser beam P include a region having even light intensity, as illustrated in Figs. 7A to 7C. However, as described below, the light intensity distribution of a laser beam does not have to be completely even but may have predetermined evenness in a predetermined region in a section orthogonal to the beam axis.

Fig. 8 is a diagram illustrating light intensity distribution of a laser beam with which a target material is irradiated. As illustrated in Fig. 8, when a difference between a value Imax of the highest light intensity in a predetermined region (diameter Dt) in the section orthogonal to the beam axis of a laser beam and a value Imin of the lowest light intensity in the region is too large, it cannot be said that the pre-pulse laser beam P has predetermined evenness. In order to make it possible to say that the pre-pulse laser beam P has predetermined evenness, it is preferable that a value of variation C shown below be equal to or less than 20(%), for example.

$$C = \{(Imax-Imin)/(Imax+Imin)\} \times 100(\%)$$

It is more preferable that the above-mentioned value of variation C be equal to or less than 10(%).

Further, in a case where the light intensity distribution in a beam section of a laser beam has a plurality of peaks P1 to P6 in the above-mentioned region having the predetermined evenness, it is preferable that an interval $\Delta P$ between the peaks be equal to or less than a half of the diameter Dd of a droplet DL.

<5. First Embodiment>

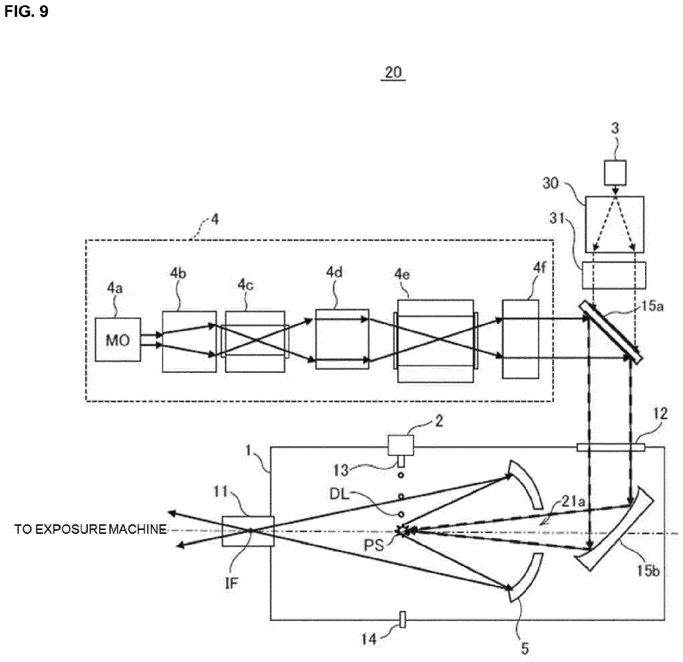

Fig. 9 is a diagram illustrating the schematic configuration of an EUV light generating apparatus according to a first embodiment. The EUV light generating apparatus according to the first embodiment employs the LPP method in which EUV light is generated by irradiating a target material with a laser beam and exciting the target material. As depicted in Fig. 9, this EUV light generating apparatus 20 may include a chamber 1, a target supply unit 2, a pre-pulse laser device 3, a main-pulse laser device 4, and an EUV collector mirror 5. Here, the pre-pulse laser device 3 and the main-pulse laser device 4 constitute a laser beam generating mechanism.

The chamber 1 is a vacuum chamber in which EUV light is generated. To the chamber 1, an exposure machine connecting port 11 and a window 12 are provided. Via the exposure machine connecting port 11, EUV light generated in the chamber 1 is outputted to an external exposure machine (reduced projection reflective optical system). Through the window 12, laser beams generated by the pre-pulse laser device 3 and the main-pulse laser device 4 enter the chamber 1.

The target supply unit 2 is a device which supplies a target material such as tin (Sn) and lithium (Li) which is used for generating EUV light into the chamber 1. In the chamber 1, the target material is jetted through a target nozzle 13 to be spherical droplets DL. The droplet DL has a diameter from 10 $\mu$m to 100 $\mu$m inclusive, for example. Droplets DL which are not irradiated with a laser beam among a plurality of droplets DL supplied into the chamber 1 are collected by a target collecting unit 14.

The pre-pulse laser device 3 and the main-pulse laser device 4 are master oscillator power amplification type laser devices which generate driving laser beams which are used for exciting a target material. Laser beams which are generated by the pre-pulse laser device 3 and the main-pulse laser device 4 are pulse laser beams having high repetitive rate (for example, pulse duration of approximate several ns to several dozen ns and repetitive rate of approximate 10 kHz to 100 kHz). The pre-pulse laser device 3 generates a pre-pulse laser beam and the main-pulse laser device 4 generates a main-pulse laser beam. A YAG (yttrium aluminum garnet) laser device, for example, is used as the pre-pulse laser device 3 and a $CO_2$ laser device, for example, is used as the main-pulse laser device 4. However, other laser devices may be used.

A pre-pulse laser beam generated by the pre-pulse laser device 3 is focused on a droplet DL in the chamber 1 via a laser focusing optical system including a beam combiner 15a and an off-axis paraboloidal mirror 15b, for example, the above-mentioned window 12, and a through-hole 21a formed on a central part of the EUV collector mirror 5.

On the other hand, a main-pulse laser beam generated by the main-pulse laser device 4 is focused on a diffused target in the chamber 1 via the laser focusing optical system including the beam combiner 15a and the off-axis paraboloidal mirror 15b, for example, the above-mentioned window 12, and the through-hole 21a.

When a droplet DL is irradiated with a pre-pulse laser beam, the droplet DL is diffused and thus a diffused target (pre-plasma shown in Figs. 2A to 2C or a broken droplet shown in Figs. 2A to 2C and Figs. 3A to 3C, for example) is formed.

A main-pulse laser beam is applied on the diffused target which is formed by irradiation of the droplet DL with the pre-pulse laser beam. When the diffused target is excited and turned into plasma by energy of the main-pulse laser beam, light with various wavelengths including EUV light is emitted.

The EUV collector mirror 5 is a collecting optical system which collects and reflects light with a predetermined wavelength (for example, EUV light having a wavelength of approximately 13.5 nm) of light with various wavelengths which is emitted from plasma. The EUV collector mirror 5 is a mirror which has a concave face like reflection surface of a spheroid surface on which a molybdenum (Mo)/silicon (Si) multi-layer film which selectively reflects EUV light with a wavelength of approximately 13.5 nm, for example, is formed. The EUV collector mirror 5 is disposed so that a first focal point of the spheroid surface is a plasma generating region PS. EUV light reflected by the EUV collector mirror 5 is focused on a second focal point of the spheroid surface, that is, on an intermediate focus (IF) so as to be outputted to the external exposure machine.

In the first embodiment, a pre-pulse laser beam which is generated by the pre-pulse laser device 3 and a main-pulse laser beam which is generated by the main-pulse laser device 4 are approximately accorded with each other in their beam axes by the beam combiner 15a so as to be supplied into the chamber 1.

The pre-pulse laser device 3 generates a pre-pulse laser beam having a first predetermined wavelength. The pre-pulse laser beam is incident on a correcting optical element 31 after the beam diameter thereof is expanded by a beam expander 30.

The correcting optical element 31 is an element for correcting light intensity distribution of a pre-pulse laser beam with which a droplet DL is irradiated. The correcting optical element 31 corrects light intensity distribution of a pre-pulse laser beam P so that a beam section, on an irradiation position of a droplet DL, of a pre-pulse laser beam includes a region in which light intensity distribution has predetermined evenness and the diameter of the region having the predetermined evenness is larger than the diameter of the droplet DL. The pre-pulse laser beam P outputted from the correcting optical element 31 is incident on the beam combiner 15a.

The main-pulse laser device 4 includes a master oscillator 4a, a pre-amplifier 4c, a main-amplifier 4e, and relay optical systems 4b, 4d, and 4f which are respectively arranged on downstream sides of the master oscillator 4a, the pre-amplifier 4c, and the main-amplifier 4e. The master oscillator 4a generates seed light having a second specific wavelength. The seed light generated by the master oscillator 4a is amplified by the pre-amplifier 4c and the main-amplifier 4e to desired light intensity so as to be incident on the beam combiner 15a as a main-pulse laser beam.

The beam combiner 15a is an optical element which transmits light which has the first specific wavelength and is included in a laser beam emitted from the pre-pulse laser device 3 with high transmittance and reflects light which has the second specific wavelength and is included in a laser beam emitted from the main-pulse laser device 4 with high reflectance. The beam combiner 15a makes a pre-pulse laser beam and a main-pulse laser beam coaxial such that the beam axis of the pre-pulse laser beam and the beam axis of the main-pulse laser beam are approximately accorded with each other, and supplies the beams into the chamber 1. Here, the beam combiner 15a may be an optical element which transmits a pre-pulse laser beam having a wavelength of 1.06 $\mu$m with high transmittance and reflects a main-pulse laser beam having a wavelength of 10.6 $\mu$m with high reflectance, for example. Concretely, the beam combiner 15a may be an optical element which is obtained by coating a diamond substrate with a multi-layer film having the above-mentioned reflection transmission property. Alternatively, the beam combiner 15a may be an optical element which reflects a pre-pulse laser beam with high reflectance and transmits a main-pulse laser beam with high transmittance. In this case, the pre-pulse laser device 3 and the main-pulse laser device 4 may be arranged in a manner that their positions are switched.

According to the first embodiment, a beam section of a pre-pulse laser beam includes a region in which light intensity distribution has predetermined evenness and the diameter of the region having the predetermined evenness is larger than the diameter of a droplet. Accordingly, variation of a position of a diffused target, which is caused by variation of a position of a droplet, can be suppressed and energy of generated EUV light and stability of optical performance can be improved.

Further, according to the first embodiment, the plasma generating region PS can be irradiated with a pre-pulse laser beam and a main-pulse laser beam in an approximate coaxial fashion. Accordingly, the number of through-holes for introducing a laser beam which are formed on the EUV collector mirror 5 can be reduced.

Though the EUV light generating apparatus 20 which includes the pre-pulse laser device 3 and the main-pulse laser device 4 is described in the first embodiment, the present disclosure is not limited to this. For example, the present invention is applicable to an apparatus which is separately manufactured from excitation energy sources such as the pre-pulse laser device 3 and the main-pulse laser device 4 and introduces excitation energy from these laser devices and the like so as to excite a target material in a chamber and generate EUV light. Thus, an apparatus which generates EUV light in combination with the pre-pulse laser device 3 and the main-pulse laser device 4 serving as external devices is referred to merely as an "apparatus" in this application.

<6. Example of Correcting Optical Element>

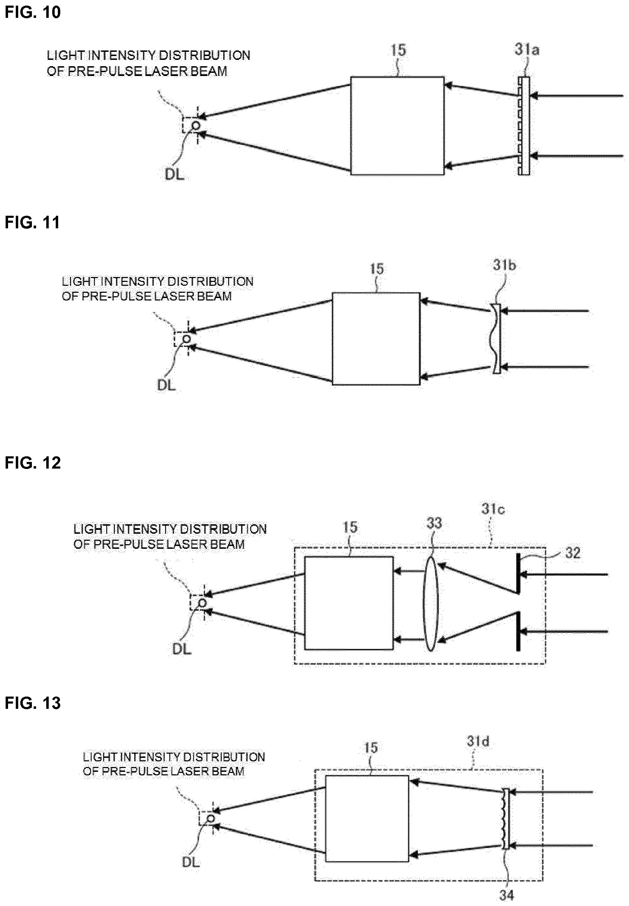

Fig. 10 is a conceptual diagram illustrating an example on a correcting optical element. A correcting optical element depicted in Fig. 10 includes a diffraction optical element 31a. The diffraction optical element 31a is composed of a transparent plate on which fine concavities and fine convexities for diffracting incident light are formed, for example. A concave and convex pattern of the diffraction optical element 31a is designed so that light intensity distribution is made even on a focus when diffracted light is focused by the focusing optical system. Diffracted light outputted from the diffraction optical element 31a is focused with a focusing optical system 15 (the off-axis paraboloidal mirror 15b depicted in Fig. 9, for example). Accordingly, a pre-pulse laser beam having top hat type light intensity distribution is applied on a droplet DL.

Fig. 11 is a conceptual diagram illustrating another example on a correcting optical element. A correcting optical element depicted in Fig. 11 includes a phase shift optical system 31b. The phase shift optical system 31b is composed of a transparent plate of which a central part is thicker than a peripheral part, for example. This phase shift optical system 31b provides a phase difference n between light transmitted through the central part and light transmitted through the peripheral part. Accordingly, incident light of which light intensity distribution exhibits Gaussian distribution is converted into output light having field intensity distribution approximate to Airy function so as to be outputted from the phase shift optical system 31b.

The focusing optical system 15 is disposed so that a rear focal point of the focusing optical system 15 is accorded with a passing point of a droplet DL, and the phase shift optical system 31b is disposed on a front focal point of the focusing optical system 15, for example. Accordingly, a pre-pulse laser beam which is obtained by Fourier-converting the Airy function and has the top hat type light intensity distribution is applied on a droplet DL. Here, the example using the phase shift optical system 31b of the transmission type is described, but, not being limited to this, a reflective type phase shift optical system may be used.

Fig. 12 is a conceptual diagram illustrating still another example on a correcting optical element. A correcting optical element depicted in Fig. 12 includes a mask 32 having an opening of a predetermined shape. The mask 32, a collimator lens 33, and the focusing optical system 15 constitute a reduced projection optical system 31c. The mask 32 transmits only light in a region, in which light intensity distribution has evenness, of an incident pre-pulse laser beam. The reduced projection optical system 31c reduces and projects an image which is on the mask 32 part, on a droplet DL by the collimator lens 33 and the focusing optical system 15 so as to form an image. Accordingly, a pre-pulse laser beam having top hat type light intensity distribution is applied on the droplet DL.

Fig. 13 is a conceptual diagram illustrating yet another example on a correcting optical element. A correcting optical element depicted in Fig. 13 includes a fly eye lens 34 in which a multitude of concave lenses are arranged. The fly eye lens 34 and the focusing optical system 15 constitute a Kohler illumination optical system 31d. The Kohler illumination optical system 31d can expand incident light by each of the concave lenses of the fly eye lens 34 at each predetermined angle and superpose the light on a focal point of the focusing optical system 15. Consequently, light intensity distribution of a laser beam can be made even on the focal point of the focusing optical system 15. Accordingly, a pre-pulse laser beam having top hat type light intensity distribution is applied on a droplet DL. Here, the example using the fly eye lens 34 is described, but, not being limited to this, a reflective type fly eye optical system may be used. Further, the fly eye lens may be composed of many convex lenses which are arranged or may be a micro fly eye lens composed of fine lenses.

Further, Figs. 10 to 13 illustrate a case where the focusing optical system having a function of focusing a laser beam on a droplet and the correcting optical element having a function of correcting light intensity distribution of the laser beams are combined, but one element may have these functions. For example, an optical element, on which concavities and convexities are formed, such as a diffraction optical element, may be used as a focusing lens and an optical element having a function of a phase shift may be used as a focusing mirror.

<7. Second Embodiment>

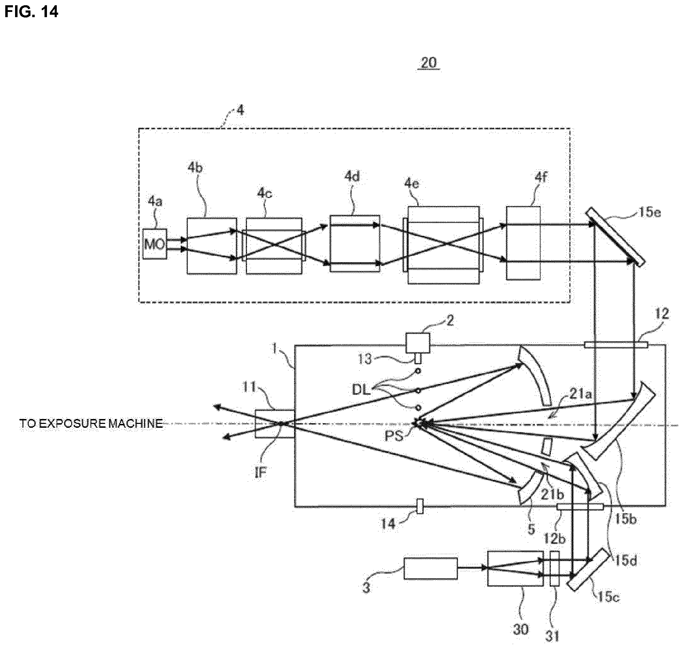

Fig. 14 is a diagram illustrating the schematic configuration of an EUV light generating apparatus according to a second embodiment. The EUV light generating apparatus according to the second embodiment has such configuration that a pre-pulse laser beam generated by the pre-pulse laser device 3 and a main-pulse laser beam generated by the main-pulse laser beam 4 are supplied into the chamber 1 through different routes.

A pre-pulse laser beam generated by the pre-pulse laser device 3 is focused on a droplet DL inside the chamber 1 via a highly reflective mirror 15c, a window 12b provided to the chamber 1, an off-axis paraboloidal mirror 15d, and one through-hole 21b formed on the EUV collector mirror 5. Accordingly, a diffused target is formed.

A main-pulse laser beam generated by the main-pulse laser device 4 is focused on a diffused target via a highly reflective mirror 15e, the window 12, the off-axis paraboloidal mirror 15b, and another through-hole 21a formed in the EUV collector mirror 5.

According to the second embodiment, a pre-pulse laser beam and a main-pulse laser beam can be applied on a target via separate optical systems. Accordingly, it becomes easy to design and manufacture optical systems so that a pre-pulse laser beam and a main-pulse laser beam respectively form focuses respectively having desired sizes. Further, a droplet DL and a diffused target can be irradiated respectively with a pre-pulse laser beam and a main-pulse laser beam from approximately the same directions even without using an optical element such as a beam combiner for making a pre-pulse laser beam and a main-pulse laser beam coaxial. Other points are the same as those of the first embodiment.

<8. Third Embodiment>

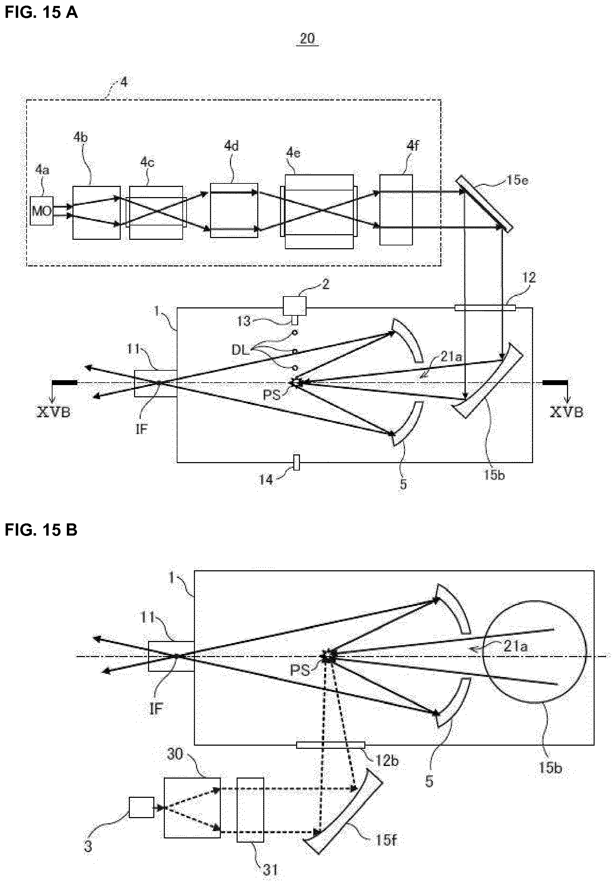

Fig. 15A is a diagram illustrating the schematic configuration of an EUV light generating apparatus according to a third embodiment, and Fig. 15B shows a section taken along an XVB-XVB line of the EUV light generating apparatus depicted in Fig. 15A. The EUV light generating apparatus according to the third embodiment has such configuration that a pre-pulse laser beam generated by the pre-pulse laser device 3 is supplied into the chamber 1 from a direction approximately orthogonal to a beam axis of EUV light via an off-axis paraboloidal mirror 15f depicted in Fig. 15B.

According to the third embodiment, there is no need to form a through-hole for introducing a pre-pulse laser beam in the EUV collector mirror 5, so that light collecting efficiency of EUV light by the EUV collector mirror 5 can be enhanced compared to the second embodiment. Other points are the same as those of the second embodiments.

<9. Fourth Embodiment>

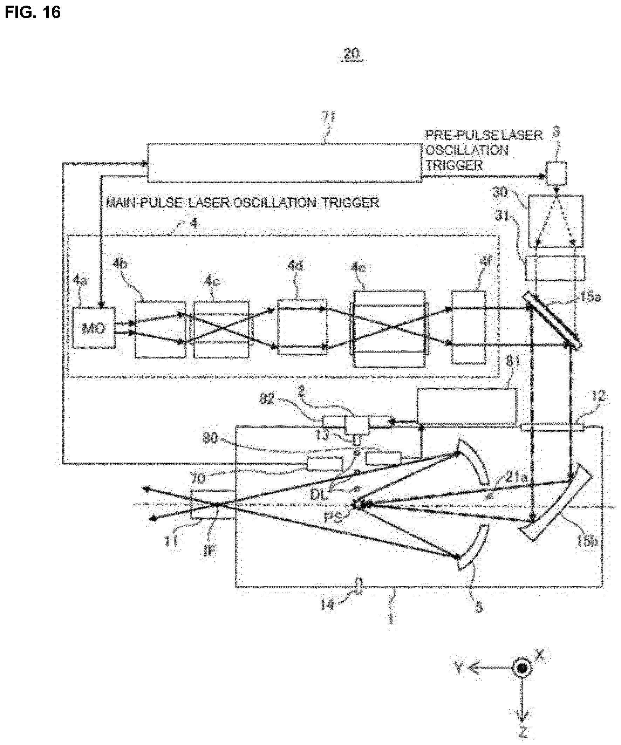

Fig. 16 is a diagram illustrating the schematic configuration of an EUV light generating apparatus according to a fourth embodiment. The EUV light generating apparatus according to the fourth embodiment has such configuration that a droplet position detecting mechanism is added to the configuration of the EUV light generating apparatus according to the first embodiment illustrated in Fig. 9. In the EUV light generating apparatus according to the fourth embodiment, emitting timing of a laser beam and the like are controlled depending on a detected position of a droplet. The droplet position detecting mechanism includes a droplet Z direction detector 70 and a droplet XY direction detector 80.

The droplet Z direction detector 70 detects a position in a traveling direction (Z direction) of a droplet. In particular, the droplet Z direction detector 70 outputs a Z position detection signal to a laser trigger generating mechanism 71 when a droplet reaches a predetermined position in the Z direction.

Receiving the Z position detection signal, the laser trigger generating mechanism 71 outputs a pre-pulse laser oscillation trigger signal to the pre-pulse laser device 3 when predetermined delay time elapses. The pre-pulse laser device 3 emits a pre-pulse laser beam in accordance with the pre-pulse laser oscillation trigger signal. The predetermined delay time is set so that the pre-pulse laser device 3 emits a pre-pulse laser beam at timing on which a droplet DL reaches a plasma generating region PS.

After the laser trigger generating mechanism 71 outputs the pre-pulse laser oscillation trigger signal to the pre-pulse laser device 3, a droplet DL is irradiated with pre-pulse laser so as to be diffused. Then, the laser trigger generating mechanism 71 outputs a main-pulse laser oscillation trigger signal to the main-pulse laser device 4 when predetermined delay time elapses. The main-pulse laser device 4 emits a main-pulse laser beam in accordance with the main-pulse laser oscillation trigger signal. The predetermined delay time is set so that the main-pulse laser device 4 emits a main-pulse laser beam at timing on which a diffused target diffuses to have a desired size.

As mentioned above, generating timing of respective pulse laser beams is controlled in accordance with a detecting result of a position of a droplet in the Z direction.

It can be considered that there are various types of jitters (fluctuation on a time axis) in the droplet Z direction detector 70, the laser trigger generating mechanism 71, and the pre-pulse laser device 3. Examples of such jitters include (1) jitter ($\sigma a$) of time required for signal output of the droplet Z direction detector, (2) jitter ($\sigma b$) of time required for signal reception/transmission, (3) jitter ($\sigma c$) of time required for signal processing, (4) jitter ($\sigma d$) of time in which a pulse laser beam is emitted from the pre-pulse laser device 3, (5) jitter ($\sigma f$) of time in which a pulse laser beam is emitted from the main-pulse laser device 4, and the like. Standard deviation $\sigma j$ of the above-mentioned jitters is expressed by the following expression.

$$\sigma j = (\sigma a^2 + \sigma b^2 + \sigma c^2 + \sigma d^2 + \sigma f^2 + \ldots)^{1/2}$$

Mismatch between an irradiation position of laser and a position of a droplet in the Z direction is expressed by $2\sigma j \times v$

(here, v denotes a moving speed of a droplet), for example. In this case, a diameter Dtz of a region, in which light intensity distribution has predetermined evenness, of a beam section of a pre-pulse laser beam may satisfy the following condition.

$$Dtz \geq Dd + 2\sigma j \times v$$

The droplet XY direction detector 80 detects a position on a plane orthogonal to the traveling direction of droplets which are sequentially supplied from the target supply unit 2 (a position of a droplet in the XY direction) and outputs an XY position detection signal to a droplet XY controller 81.

When the droplet XY controller 81 receives the XY position detection signal, the droplet XY controller 81 determines whether a detected position of a droplet is within a predetermined allowable range or not. When the position of a droplet is not within the predetermined allowable range, the droplet XY controller 81 outputs an XY driving signal to a droplet XY controlling mechanism 82.

The droplet XY controlling mechanism 82 drives a driving motor which is provided to the target supply unit 2 in accordance with the XY driving signal so as to control an output position of a droplet. As described above, an output position of a droplet in the XY direction is controlled in accordance with a detecting result of a position of a droplet in the XY direction.

Here, even in such controlling case, an output position cannot be changed for every droplet. Accordingly, when short-period fluctuation (standard deviation) in the XY direction is denoted as ox, it is preferable that a diameter Dtx of a region, in which light intensity distribution has predetermined evenness, of a beam section of a pre-pulse laser beam satisfy the following condition, for example.

$$Dtx \geq Dd + 2\sigma x$$

The example in which an output position of a droplet is controlled in the XY direction is illustrated in the fourth embodiment, but, not being limited to this, an output angle of a droplet which is outputted from the nozzle 13 may be controlled.

<10. Fifth Embodiment>

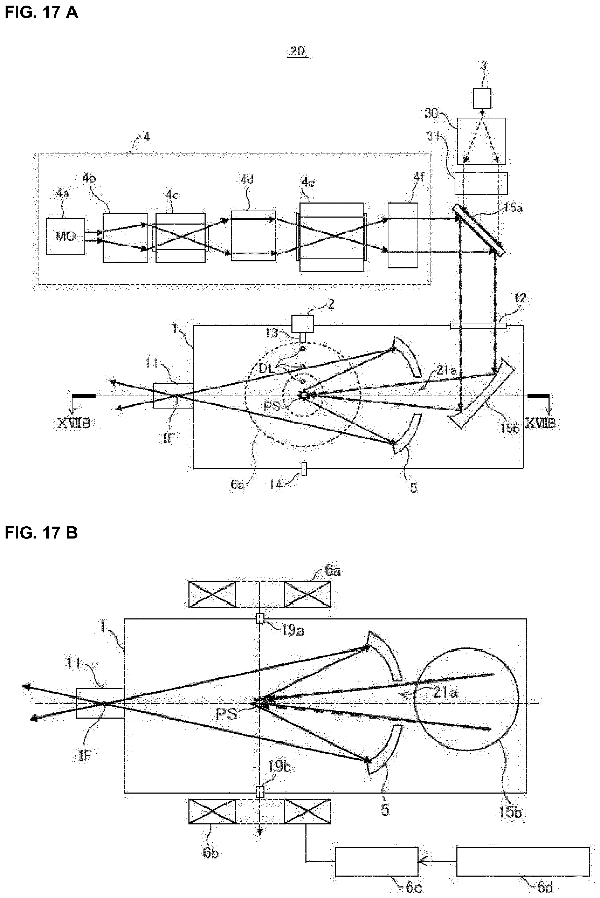

Fig. 17A is a diagram illustrating the schematic configuration of an EUV light generating apparatus according to a fifth embodiment, and Fig. 17B is a sectional view taken along an XVIIB-XVIIB line of the EUV light generating apparatus depicted in Fig. 17A. The EUV light generating apparatus according to the fifth embodiment has such configuration that magnets 6a and 6b are added to the EUV light generating apparatus according to the first embodiment depicted in Fig. 9. In the fifth embodiment, ions generated in the chamber 1 are collected by forming a magnetic field in the chamber 1 by the magnets 6a and 6b.

The magnets 6a and 6b are electromagnets which include coil winding, a cooling mechanism of coil winding, and the like. To these magnets 6a and 6b, a power source device 6c which is controlled by a power source controller 6d is connected. The power source controller 6d controls electric current which is supplied from the power source device 6c to the magnets 6a and 6b, and accordingly, a magnetic field in a predetermined direction is formed in the chamber 1. As the magnets 6a and 6b, a superconductive electromagnet is used, for example. Here, the example in which two pieces of magnets 6a and 6b are used is described, but one piece of magnet may be used. Further, a permanent magnet may be used. Furthermore, the magnet may be disposed inside the chamber.

Plasma, which is generated by irradiation with a main-pulse laser beam, of a target material includes a positive ion and a negative ion (or electron). Positive ions and negative ions moving inside the chamber 1 receive Lorentz force in the magnetic field so as to spirally move along a magnetic line. Accordingly, ions of the target material are trapped by the magnetic field and are collected by ion collectors 19a and 19b which are provided in the magnetic field. Accordingly, scattering of ions in the chamber 1 can be suppressed and deterioration of an optical element, which is caused by attachment of ions to the optical element such as the EUV collector mirror 5 in the chamber, of the inside of the chamber can be suppressed. Here, in Fig. 17B, the magnetic field faces the lower direction of the paper plane, but a similar function can be obtained even if the magnetic field faces the upper direction of the paper plane.

The mitigation technique to mitigate contamination by ions is not limited to a technique using a magnetic field, but may be a technique to etch a material contaminating the EUV collector mirror 5 and the like, by using etching gas. Further, the mitigation technique may be a technique in which hydrogen gas ($H_2$) or hydrogen radical (H) is allowed to act in the magnetic field to eliminate ions.

<11. Sixth Embodiment>

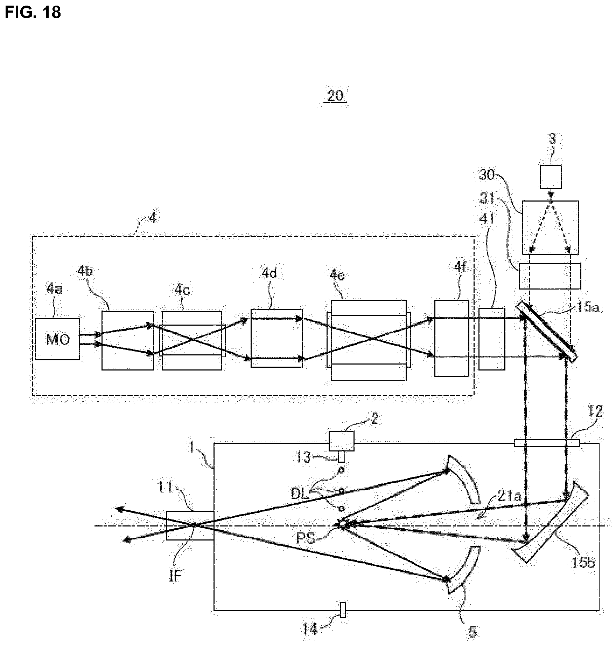

Fig. 18 is a diagram illustrating the schematic configuration of an EUV light generating apparatus according to a sixth embodiment. The EUV light generating apparatus according to the sixth embodiment includes a correcting optical element 41 which corrects light intensity distribution of a main-pulse laser beam and is provided between the main-pulse laser device 4 and the beam combiner 15a.

The configuration of the correcting optical element 41 is the same as the configuration of the correcting optical element 31 which corrects light intensity distribution of a pre-pulse laser beam. The correcting optical element 41 corrects so that light intensity distribution has predetermined evenness in a beam section of a main-pulse laser beam. Accordingly, a diffused target can be evenly irradiated with a main-pulse laser beam. Other points are the same as those of the first embodiment.

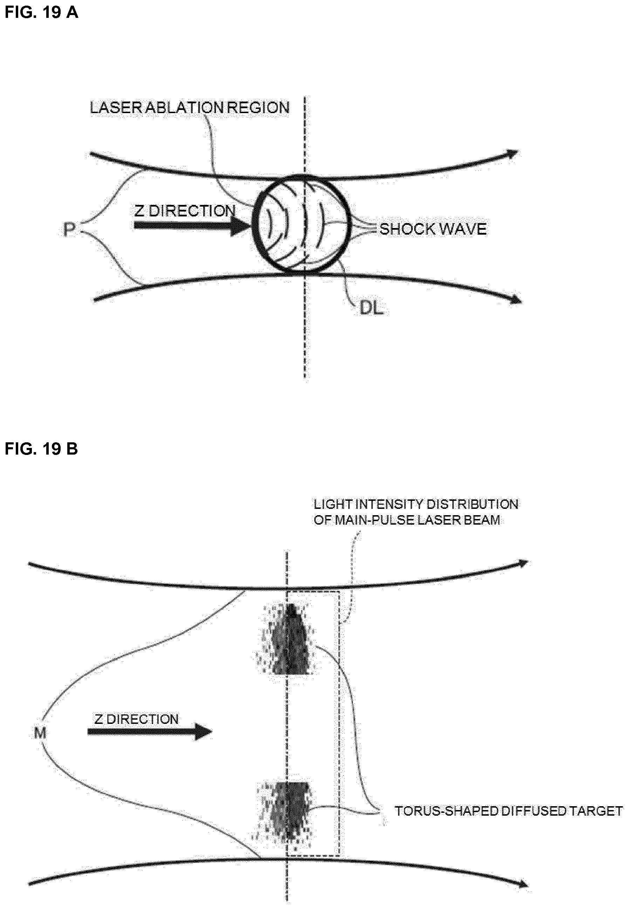

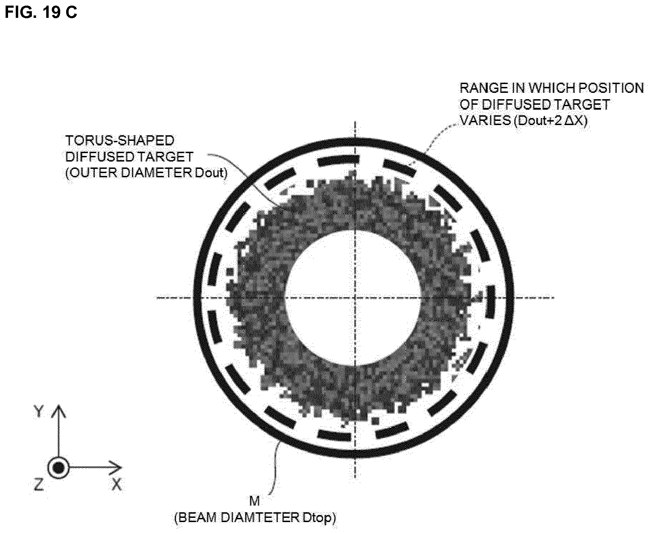

Fig. 19A is a conceptual diagram illustrating a state that a droplet is irradiated with a pre-pulse laser beam. Figs. 19B and 19C are conceptual diagrams illustrating a state that a torus-shaped diffused target which is formed by irradiating a droplet with a pre-pulse laser beam is irradiated with a main-pulse laser beam having top hat type light intensity distribution. Figs. 19A and 19B show a target material viewed from a direction orthogonal to beam axes of a pre-pulse laser beam P and a main-pulse laser beam M. Fig. 19C shows a target material viewed from a direction of the beam axis of a main-pulse laser beam M.

As illustrated in Fig. 19A, when a pre-pulse laser beam P is focused and applied on a droplet DL, laser ablation occurs around a surface of the droplet DL irradiated with the pre-pulse laser beam P. Consequently, a shock wave is generated inward the droplet DL from the surface of the droplet DL which is irradiated with the pre-pulse laser beam P, due to energy of the laser ablation. This shock wave propagates through the whole of the droplet DL. Here, when light intensity of the pre-pulse laser beam P is equal to or larger than light intensity of a first predetermined value (for example, $1 \times 10^9$ W/cm$^2$), the droplet DL is shattered by this shock wave to be diffused.

Further, when light intensity of the pre-pulse laser beam P is equal to or larger than light intensity of a second predetermined value (for example, $6.4 \times 10^9$ W/cm$^2$), the droplet DL is shattered and a torus-shaped diffused target shown in Figs. 19B and 19C may be formed. As depicted in Figs. 19B and 19C, a torus-shaped diffused target is formed such that a droplet DL is diffused symmetrically about the beam axis of the pre-pulse laser beam P in a manner to have a torus shape.

Here, a specific condition for forming a torus-shaped diffused target is as follows, for example. A light intensity range of a pre-pulse laser beam P is from $6.4 \times 10^9$ W/cm$^2$ to $3.2 \times 10^{10}$ W/cm$^2$ inclusive. A diameter of a droplet DL is from 12 $\mu$m to 40 $\mu$m inclusive.

Irradiation of a torus-shaped diffused target with a main-pulse laser beam M is now described. A torus-shaped diffused target is formed at timing from 0.5 $\mu$s to 2.0 $\mu$s, for example, after a droplet DL is irradiated with a pre-pulse laser beam P. Accordingly, it is preferable that a diffused target be irradiated with a main-pulse laser beam M at the above-mentioned timing after the irradiation of the droplet DL with the pre-pulse laser beam P.

Further, as depicted in Figs. 19B and 19C, in a shape of a torus-shaped diffused target, the length in the beam axis direction of the pre-pulse laser beam P is shorter than the length in a direction orthogonal to the beam axis direction of the pre-pulse laser beam P. It is preferable that this diffused target be irradiated with the main-pulse laser beam M in approximately the same direction as the pre-pulse laser beam P. Accordingly, the diffused target can be more evenly irradiated with the main-pulse laser beam M and a target material can be allowed to efficiently absorb the main-pulse laser beam M. Therefore, there is a case where CE in an LPP type EUV light generating apparatus can be enhanced.

At least light intensity distribution in a beam section of a main-pulse laser beam M is corrected by the correcting optical element 41, which has been described with reference to Fig. 18, so as to have predetermined evenness. Here, in terms of an object of generating a torus-shaped diffused target, the light intensity distribution in the beam section of the pre-pulse laser beam P does not have to have predetermined evenness. In a case specific to this object, the correcting optical element 31 does not have to be provided in the sixth embodiment illustrated in Fig. 18. However, not limited to this, the correcting optical element 31 may be provided to suppress variation of a position of a diffused target, which is caused by variation of a position of a droplet.

It is presumed that plasma is cylindrically discharged from a torus-shaped diffused target by irradiating the torus-shaped diffused target with a main-pulse laser beam of which light intensity distribution has predetermined evenness. Further, such effect that plasma diffusing inward the cylinder is closed in the cylinder can be expected. Accordingly, it can be expected that plasma is generated at a high temperature and high density and CE is improved. Here, "torus-shaped" means an annular shape. However, a diffused target does not necessarily have the annular body, but a diffused target may be substantively annularly diffused.

Here, when variation of a position of a torus-shaped diffused target is denoted as $\Delta$X, it is preferable that a diameter Dtop of a region, in which light intensity distribution has predetermined evenness, of a main-pulse laser beam M have the following relationship with respect to an outer diameter Dout of a torus-shaped diffused target.

$$Dtop \geq Dout + 2\Delta X$$

That is, it is preferable that the diameter Dtop of the region, in which the light intensity distribution has predetermined evenness, of a beam section of the main-pulse laser beam M be equal to or larger than a sum obtained by adding the double of the variation $\Delta X$ of a position of a diffused target to the outer diameter Dout of a torus-shaped diffused target. Accordingly, the whole of the torus-shaped diffused target can be irradiated with a main-pulse laser beam M having even light intensity. Therefore, larger part of the diffused target can be turned into plasma. As a result, generation of debris of a target material can be suppressed.

<12. Seventh Embodiment>

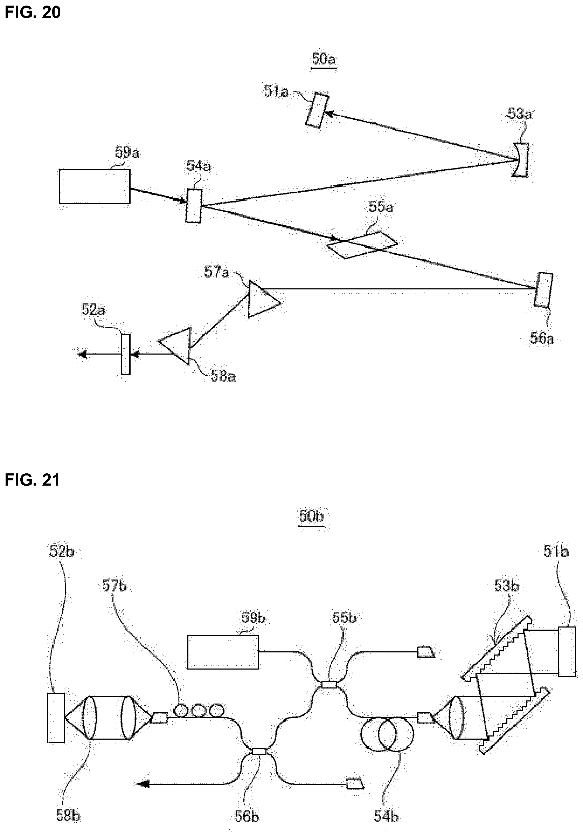

Fig. 20 is a conceptual diagram illustrating a configuration example of a titanium sapphire laser which generates a pre-pulse laser beam in an EUV light generating apparatus according to a seventh embodiment. A titanium sapphire laser 50a according to the seventh embodiment is provided outside the chamber as the pulse laser device which generates a pre-pulse laser beam for diffusing a droplet in the above-mentioned first to sixth embodiments.

The titanium sapphire laser 50a according to the seventh embodiment includes a laser resonator in which a concave face mirror 53a, a first pumping mirror 54a, a titanium sapphire crystal 55a, a second pumping mirror 56a, and two prisms 57a and 58a are disposed in this order from a semiconductor saturable absorbing mirror 51a side, between the semiconductor saturable absorbing mirror 51a and an output coupling mirror 52a. The titanium sapphire laser 50a further includes an excitation light source 59a which introduces excitation light to this laser resonator.

The first pumping mirror 54a is a mirror which transmits excitation light from the outside of the laser resonator with high transmittance and reflects light from the inside of the laser resonator with high reflectance. The titanium sapphire crystal 55a is a laser medium which receives excitation light and performs stimulated emission. The two prisms 57a and 58a selectively transmit light having a specific wavelength. The output coupling mirror 52a transmits and outputs part of light which is amplified in this laser resonator and reflects other part of the light to return the part into the laser resonator. The semiconductor saturable absorbing mirror 51a is a mirror in which a reflection layer and a saturable absorber layer are layered, and shortens a pulse of incident light such that part, in which light intensity is low, of incident light is absorbed by the saturable absorber layer and part, of which the light intensity is high, of the incident light is transmitted by the saturable absorber layer and reflected by the reflection layer.

As the excitation light source 59a, a semiconductor excitation $Nd:YVO_4$ laser is used, for example. Second harmonic light from this excitation light source 59a is introduced into the laser resonator via the first pumping mirror 54a. The position of the semiconductor saturable absorbing mirror 51a is adjusted and oscillation is caused in a manner to synchronize a longitudinal mode of the laser resonator so as to output a pulse laser beam having a pulse duration of a picosecond order from the output coupling mirror 52a. Here, when pulse energy is small, the pulse laser beam may be amplified by a regenerative amplifier.

According to the seventh embodiment, a droplet is irradiated with a short pulse laser beam having a pulse duration of a picosecond order as a pre-pulse laser beam, so that the droplet can be diffused with small pulse energy.

<13. Eighth Embodiment>

Fig. 21 is a conceptual diagram illustrating a configuration example of a fiber laser which generates a pre-pulse laser beam in an EUV light generating apparatus according to an eighth embodiment. A fiber laser 50b according to the eighth embodiment is provided outside the chamber as the pulse laser device which generates a pre-pulse laser beam for diffusing a droplet in the above-mentioned first to sixth embodiments.

The fiber laser 50b according to the eighth embodiment includes a laser resonator in which a grating pair 53b, a first polarization maintaining fiber 54b, a multiplexer 55b, an isolation element 56b, a second polarization maintaining fiber 57b, and a focusing optical system 58b are disposed in this order from a high reflection mirror 51b side, between the high reflection mirror 51b and a semiconductor saturable absorbing mirror 52b. The fiber laser 50b further includes an excitation light source 59b which introduces excitation light to this laser resonator.

The multiplexer 55b introduces excitation light from the excitation light source 59b to the first polarization maintaining fiber 54b and at the same time, transmits light between the first polarization maintaining fiber 54b and the second polarization maintaining fiber 57b. To the first polarization maintaining fiber 54b, ytterbium (Yb) is doped, and the first polarization maintaining fiber 54b receives excitation light and performs stimulated emission. The grating pair 53b selectively reflects light having a specific wavelength. The semiconductor saturable absorbing mirror 52b is a mirror in which a reflection layer and a saturable absorber layer are layered, and shortens a pulse of incident light such that part, in which light intensity is low, of incident light is absorbed by the saturable absorber layer and part, in which the light intensity is high, of the incident light is transmitted by the saturable absorber layer and reflected by the reflection layer. The isolation element 56b isolates and outputs part of light which is amplified in this laser resonator and returns other part of the light into the laser resonator. When excitation light is introduced from the excitation light source 59b which is connected to the multiplexer 55b by an optical fiber, a pulse laser beam having a pulse duration of a picosecond order is outputted via the isolation element 56b.

Here, a picosecond pulse laser which emits a pulse laser beam having a pulse duration of a picosecond order represents a pulse laser which emits a pulse laser beam of which a pulse duration T is less than 1 ns (T<1 ns). Further, a similar advantageous effect can be obtained when a femtosecond pulse laser which emits a pulse laser beam having a pulse duration of a femtosecond order is applied.

According to the eighth embodiment, the same advantageous effect as the seventh embodiment is obtained and a pre-pulse laser beam can be introduced by an optical fiber, so that a traveling direction of a pre-pulse laser beam is easily adjusted.

Here, as a wavelength of a laser beam is shorter, an absorption rate of a laser beam by tin is increased. Accordingly, when absorption by tin is emphasized, a shorter wavelength is more advantageous. For example, with respect to a wavelength 1064 nm of a fundamental wave emitted from a Nd:YAG laser, the absorption rate increases in an order of harmonic $2\omega$=532 nm, $3\omega$=355 nm, and $4\omega$=266 nm.

Here, the example using the short pulse laser beam having the pulse duration of a picosecond order has been described, but a droplet can be diffused by using a pulse laser beam having a pulse duration of a nanosecond order as well. For example, a fiber laser of which a pulse duration is approximately 15 ns, a repetition rate is 100 kHz, pulse energy is 1.5 mJ, a wavelength is 1.03 $\mu$m, and $M^2$ value is less than 1.5 is sufficiently applicable.

<14. Irradiation Condition of Pre-Pulse Laser Beam>

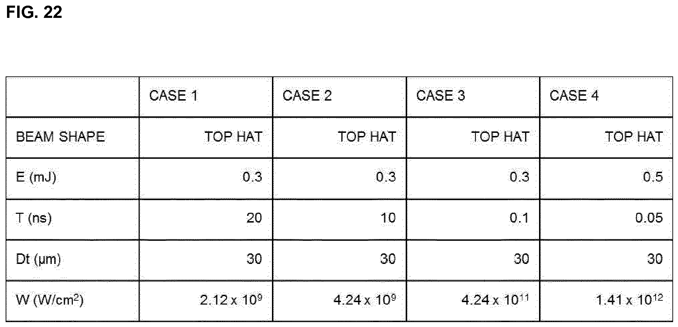

Fig. 22 is a table illustrating an example of an irradiation condition of a pre-pulse laser beam in the present disclosure. When irradiation pulse energy is denoted as E (J), pulse duration is denoted as T (s), and a diameter of a region in which light intensity distribution has predetermined evenness is denoted as Dt (m), light intensity W ($W/m^2$) of a laser beam is expressed by the following expression.

$$W = E/(T(Dt/2)^2\Pi)$$

Fig. 22 shows four examples (case 1 to case 4) as irradiation conditions of a pre-pulse laser beam. In case 1 to case 4, a case where a diameter of a droplet of molten metal tin is 10 $\mu$m and a diameter Dt of a region in which light intensity distribution has predetermined evenness is 30 $\mu$m, for example, is assumed. When irradiation pulse energy E and pulse duration T are respectively set to 0.3 mJ and 20 ns (case 1) in order to diffuse such droplet and form a desired diffused target, light intensity W of a laser beam of $2.12\times10^9$ $W/cm^2$ is obtained. Such pre-pulse laser beam enables formation of a diffused target shown in Fig. 2B, for example.

Case 2 of Fig. 22 is a case where irradiation pulse energy E and pulse duration T are respectively set to 0.3 mJ and 10 ns, and in this case, light intensity W of a laser beam of $4.24\times10^9$ $W/cm^2$ is obtained. Such pre-pulse laser beam enables formation of a diffused target shown in Fig. 2B, for example.

Case 3 of Fig. 22 is a case where irradiation pulse energy E and pulse duration T are respectively set to 0.3 mJ and 0.1 ns, and in this case, light intensity W of a laser beam of $4.24\times10^{11}$ $W/cm^2$ is obtained. Such pre-pulse laser beam enables formation of a diffused target shown in Fig. 3B, for example.

Case 4 of Fig. 22 is a case where irradiation pulse energy E and pulse duration T are respectively set to 0.5 mJ and 0.05 ns, and in this case, light intensity W of a laser beam of $1.41\times10^{12}$ $W/cm^2$ is obtained. Such pre-pulse laser beam enables formation of a diffused target shown in Fig. 3B, for example. Thus, high light intensity W can be obtained by shortening a pulse of a laser beam to a picosecond order.

The example with respect to a droplet having a diameter of 10 $\mu$m is illustrated in Fig. 22, but the present disclosure is not limited to this droplet diameter. For example, the diameter Dt of a region having predetermined evenness may be set to 30 $\mu$m as long as stability of a position of a droplet satisfies $\Delta X$=7 $\mu$m with respect to a droplet having a diameter of 16 $\mu$m.

<15. Ninth Embodiment>

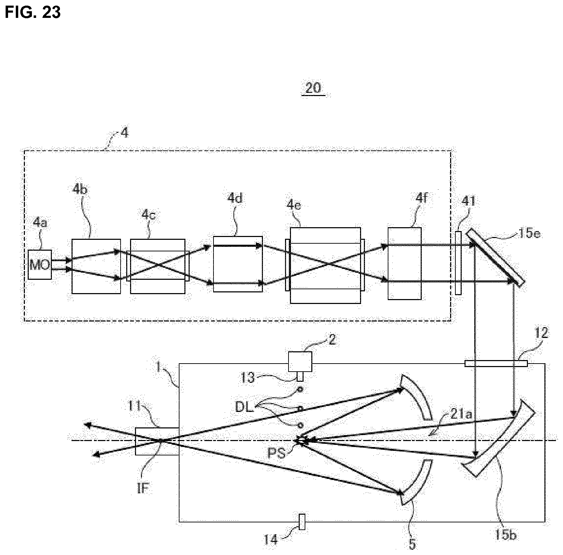

Fig. 23 is a diagram illustrating the schematic configuration of an EUV light generating apparatus according to a ninth embodiment. The EUV light generating apparatus according to the ninth embodiment is different from the EUV light generating apparatus according to the sixth embodiment, which is described with reference to Fig. 18, on the point that the EUV light generating apparatus according to the ninth embodiment does not include the pre-pulse laser device 3 (refer to Fig. 18) and turns a target material into plasma only by a main-pulse laser beam.

In the ninth embodiment, the correcting optical element 41 corrects light intensity distribution of a main-pulse laser beam so that a region having predetermined evenness exists. According to this configuration, even if a position of a droplet changes within a range in which light intensity of a main-pulse laser beam is even, change in irradiation intensity with respect to a droplet is small. As a result, stability of density of generated plasma can be enhanced and stability of intensity of EUV light can be improved. Other points are same as those of the sixth embodiment.

<16. Tenth Embodiment>

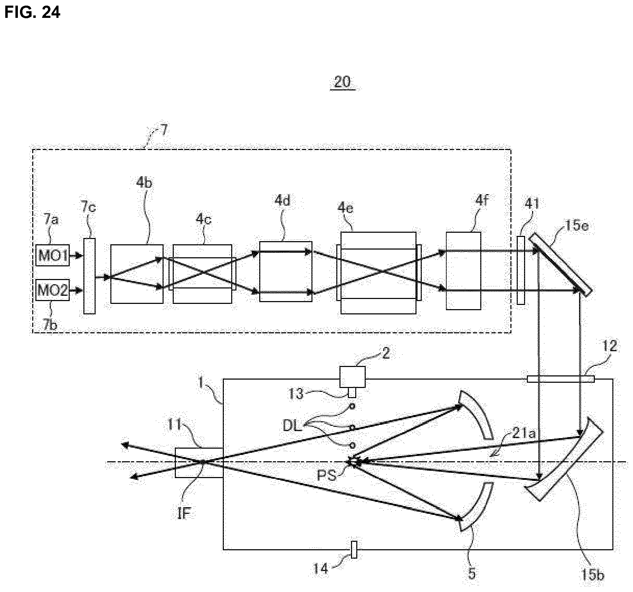

Fig. 24 is a diagram illustrating the schematic configuration of an EUV light generating apparatus according to a tenth embodiment. The EUV light generating apparatus according to the tenth embodiment includes a laser device 7 which emits both a pre-pulse laser beam and a main-pulse laser beam.

The laser device 7 includes a first master oscillator 7a, a second master oscillator 7b, an optical path regulator 7c, a pre-amplifier 4c, a main-amplifier 4e, and relay optical systems 4b, 4d, and 4f. The first master oscillator 7a generates seed light of a pre-pulse laser beam. The second master oscillator 7b generates seed light of a main-pulse laser beam. These seed lights generated by the first master oscillator 7a and the second master oscillator 7b are preferably laser beams having the same wavelength bands. The optical path regulator 7c regulates optical paths of these seed lights to be spatially approximately the same as each other and outputs the seed lights to the relay optical system 4b.

A pre-pulse laser beam and a main-pulse laser beam emitted from the laser device 7 are both corrected by the correcting optical element 41 so that the laser beam has a region in which light intensity distribution has predetermined evenness. If a pre-pulse laser beam and a main-pulse laser beam are laser beams having the same wavelength bands, light intensity distribution of these laser beams can be corrected by a single piece of correcting optical element 41. Other points are the same as those of the sixth embodiment.

The above-described embodiments are merely examples for implementing the present disclosure, and the present disclosure is not limited thereto. Accordingly, it will be apparent to those skilled in the art that modifications may be made to the embodiments of the present disclosure without departing from the scope of the present disclosure.

The terms used in this specification and the appended claims should be interpreted as "non-limiting." For example, the terms "comprise" and "be comprised" should be interpreted as "not limited to the stated elements." The term "have" should be interpreted as "not limited to the stated elements." Further, the modifier "one (a/an)" in this specification and the appended claims should be interpreted as "at least one" or "one or more."

**Claims**

1. A chamber device that is used with at least one laser beam generating device, comprising:

   a chamber (1) provided with at least one incident port for introducing at least one laser beam, the laser beam being emitted from the at least one laser beam generating device, to an inside thereof;
   a target supply unit (2) provided to the chamber (1) and supplies a target material to a predetermined region in the chamber (1);
   a laser focusing optical system (15a, 15b) configured to focus the at least one laser beam in the predetermined region; and
   an optical element (31) configured to correct light intensity distribution of a beam section, in the predetermined region, of the at least one laser beam,
   wherein the optical element (31) is configured to correct the light intensity distribution so that the light intensity distribution of the beam section, in the predetermined region, of the at least one laser beam has predetermined evenness in the predetermined region of the beam section, the at least one laser beam having predetermined evenness when a value of variation C shown below be equal to or less than 20(%);

$$C = \{(Imax - Imin)/(Imax + Imin)\} \times 100(\%),$$

   Imax: the highest light intensity in a predetermined region in the section orthogonal to the beam axis of a laser beam,
   Imin: the lowest light intensity in the predetermined region in the section orthogonal to the beam axis of a laser beam;

**characterized in that**
a minimum value of a dimension of the predetermined region in a direction orthogonal to the traveling direction of the laser beam is equal to or larger than a value obtained by adding a range of variation of a position of the target material in the predetermined region to a maximum value of a dimension in the orthogonal direction.

2. The chamber device according to Claim 1, wherein an area of the predetermined region is larger than a maximum area in a section, the section being orthogonal to a traveling direction of the at least one laser beam, of the target material in the predetermined region in the chamber (1).

3. The chamber device according to Claim 1, wherein difference between lowest light intensity and highest light intensity is equal to or less than 20% of a sum of the lowest light intensity and the highest light intensity, in the predetermined region.

4. The chamber device according to Claim 1, wherein the target material supplied into the chamber (1) is a droplet.

5. The chamber device according to Claim 1, wherein the target material includes metal.

6. A chamber device that is used with at least one laser beam generating device, comprising:

a chamber (1) provided with at least one incident port for introducing at least one laser beam, the laser beam being emitted from the at least one laser beam generating device, to an inside thereof;
a target supply unit (2) provided to the chamber (1) and supplies a target material to a predetermined region in the chamber (1);
a laser focusing optical system (15a, 15b) configured to focus the at least one laser beam in the predetermined region; and
an optical element (31) configured to correct light intensity distribution of a beam section, in the predetermined region, of the at least one laser beam wherein
the at least one laser beam includes a pre-pulse laser beam with which the target material supplied into the chamber (1) is irradiated and a main-pulse laser beam with which the target material irradiated with the pre-pulse laser beam is irradiated, and

the optical element (31) is configured to correct the light intensity distribution of the pre-pulse laser beam, the pre-pulse laser beam having predetermined evenness when a value of variation C shown below be equal to or less than 20(%);

$$C = \{(Imax-Imin)/(Imax+Imin)\} \times 100(\%),$$

Imax: the highest light intensity in a predetermined region in the section orthogonal to the beam axis of a pre-pulse laser beam,
Imin: the lowest light intensity in the predetermined region in the section orthogonal to the beam axis of a pre-pulse laser beam;

**characterized in that**
a minimum value of a dimension of a beam section, in the predetermined region, of the main-pulse laser beam is equal to or larger than a value obtained by adding a range of variation of a position of the target material irradiated with the pre-pulse laser beam to a maximum value of a dimension, in a direction orthogonal to a traveling direction of the main-pulse laser beam, of the target material irradiated with the pre-pulse laser beam.

7. The chamber device according to Claim 6, wherein an area of a beam section, in the predetermined region, of the main-pulse laser beam is larger than a maximum area, in a section orthogonal to a traveling direction of the main-pulse laser beam, of the target material irradiated with the pre-pulse laser beam.

8. The chamber device according to Claim 1, wherein
the at least one laser beam includes a pre-pulse laser beam with which the target material supplied into the chamber

16

(1) is irradiated and a main-pulse laser beam with which the target material irradiated with the pre-pulse laser beam is irradiated, and
the pre-pulse laser beam and the main-pulse laser beam are incident on an inside of the chamber (1) from approximately same directions.

**Patentansprüche**

1. Kammervorrichtung, die mit mindestens einer Laserstrahlerzeugungsvorrichtung verwendet wird, die aufweist:

   eine Kammer (1), die mit mindestens einer Einfallsöffnung zum Einleiten von mindestens einem Laserstrahl in ein Inneres davon versehen ist, wobei der Laserstrahl von der mindestens einen Laserstrahlerzeugungsvorrichtung emittiert wird;
   eine Targetzuführungseinheit (2), die für die Kammer (1) vorgesehen ist und einem vorgegebenen Bereich in der Kammer (1) ein Targetmaterial zuführt;
   eine optisches Laserfokussierungssystem (15a, 15b), das konfiguriert ist, den mindestens einen Laserstrahl im vorgegebenen Bereich zu fokussieren; und
   ein optisches Element (31), das konfiguriert ist, im vorgegebenen Bereich eine Lichtintensitätsverteilung eines Strahlquerschnitts des mindestens einen Laserstrahls zu korrigieren,
   wobei das optische Element (31) konfiguriert ist, die Lichtintensitätsverteilung so zu korrigieren, dass im vorgegebenen Bereich die Lichtintensitätsverteilung des Strahlquerschnitts des mindestens einen Laserstrahls eine vorgegebene Gleichmäßigkeit im vorgegebenen Bereich des Strahlquerschnitts aufweist, wobei der mindestens eine Laserstrahl eine vorgegebene Gleichmäßigkeit aufweist, wenn ein Wert einer unten gezeigten Variation C gleich oder kleiner als 20 (%) ist;

$$C = \{ (Imax-Imin) / (Imax+Imin) \} \times 100 \ (\%),$$

   Imax: die höchste Lichtintensität in einem vorgegebenen Bereich im Querschnitt orthogonal zur Strahlachse eines Laserstrahls,
   Imin: die niedrigste Lichtintensität im vorgegebenen Bereich im Querschnitt orthogonal zur Strahlachse eines Laserstrahls;

   **dadurch gekennzeichnet, dass**
   ein Minimalwert einer Abmessung des vorgegebenen Bereichs in eine Richtung orthogonal zur Ausbreitungsrichtung des Laserstrahls gleich oder größer als ein Wert ist, der durch Addieren eines Variationsbereichs einer Position des Targetmaterials im vorgegebenen Bereich zu einem Maximalwert einer Abmessung in die orthogonale Richtung erhalten wird.

2. Kammervorrichtung nach Anspruch 1, wobei eine Fläche des vorgegebenen Bereichs größer als eine maximale Fläche in einem Querschnitt des Targetmaterials im vorgegebenen Bereich in der Kammer (1) ist, wobei der Querschnitt orthogonal zu einer Ausbreitungsrichtung des mindestens einen Laserstrahls ist.

3. Kammervorrichtung nach Anspruch 1, wobei eine Differenz zwischen der niedrigsten Lichtintensität und der höchsten Lichtintensität gleich oder kleiner als 20% einer Summe der niedrigsten Lichtintensität und der höchsten Lichtintensität im vorgegebenen Bereich ist.

4. Kammervorrichtung nach Anspruch 1, wobei das der Kammer (1) zugeführte Targetmaterial ein Tröpfchen ist.

5. Kammervorrichtung nach Anspruch 1, wobei das Targetmaterial Metall enthält.

6. Kammervorrichtung, die mit mindestens einer Laserstrahlerzeugungsvorrichtung verwendet wird, die aufweist:

   eine Kammer (1), die mit mindestens einer Einfallsöffnung zum Einleiten von mindestens einem Laserstrahl in ein Inneres davon versehen ist, wobei der Laserstrahl von der mindestens einen Laserstrahlerzeugungsvorrichtung emittiert wird;
   eine Targetzuführungseinheit (2), die für die Kammer (1) vorgesehen ist und einem vorgegebenen Bereich in der Kammer (1) ein Targetmaterial zuführt;

eine optisches Laserfokussierungssystem (15a, 15b), das konfiguriert ist, den mindestens einen Laserstrahl im vorgegebenen Bereich zu fokussieren; und

ein optisches Element (31), das konfiguriert ist, eine Lichtintensitätsverteilung eines Strahlquerschnitts im vorgegebenen Bereich des mindestens einen Laserstrahls zu korrigieren, wobei

der mindestens eine Laserstrahl einen Vorimpuls-Laserstrahl, mit dem das der Kammer (1) zugeführte Targetmaterial bestrahlt wird, und einen Hauptimpuls-Laserstrahl umfasst, mit dem das mit dem Vorimpuls-Laserstrahl bestrahlte Targetmaterial bestrahlt wird, und

das optische Element (31) konfiguriert ist, die Lichtintensitätsverteilung des Vorimpuls-Laserstrahls zu korrigieren, wobei der Vorimpuls-Laserstrahl eine vorgegebene Gleichmäßigkeit aufweist, wenn ein Wert einer unten gezeigten Variation C gleich oder kleiner als 20 (%) ist;

$$C = \{ (Imax-Imin) / (Imax+Imin) \} \times 100 \ (\%),$$

Imax: die höchste Lichtintensität in eine vorgegebenen Bereich im Querschnitt orthogonal zur Strahlachse eines Vorimpuls-Laserstrahls,

Imin: die niedrigste Lichtintensität im vorgegebenen Bereich im Querschnitt orthogonal zur Strahlachse eines Vorimpuls-Laserstrahls;

**dadurch gekennzeichnet, dass**

im vorgegebenen Bereich ein Minimalwert einer Abmessung eines Strahlquerschnitts des Hauptimpuls-Laserstrahls gleich oder größer als ein Wert ist, der durch Addieren eines Variationsbereichs einer Position des mit dem Vorimpuls-Laserstrahl bestrahlten Targetmaterials im vorgegebenen Bereich zu einem Maximalwert einer Abmessung in eine Richtung orthogonal zu einer Ausbreitungsrichtung des Hauptimpuls-Laserstrahls des mit dem Vorimpuls-Laserstrahl bestrahlten Targetmaterials erhalten wird.

7. Kammervorrichtung nach Anspruch 6, wobei im vorgegebenen Bereich eine Fläche eines Strahlquerschnitts des Hauptimpuls-Laserstrahls größer als eine maximale Fläche in einem Querschnitt orthogonal zu einer Ausbreitungsrichtung des Hauptimpuls-Laserstrahls des mit dem Vorimpuls-Laserstrahl bestrahlten Targetmaterials ist.

8. Kammervorrichtung nach Anspruch 1, wobei der mindestens eine Laserstrahl einen Vorimpuls-Laserstrahl, mit dem das der Kammer (1) zugeführte Targetmaterial bestrahlt wird, und einen Hauptimpuls-Laserstrahl umfasst, mit dem das mit dem Vorimpuls-Laserstrahl bestrahlte Targetmaterial bestrahlt wird, und der Vorimpuls-Laserstrahl und der Hauptimpuls-Laserstrahl aus annähernd denselben Richtungen in ein Inneres der Kammer (1) einfallen.

## Revendications

1. Dispositif de chambre utilisé avec au moins un dispositif de génération de faisceau laser, comprenant :

une chambre (1) pourvue d'au moins une ouverture d'incidence pour l'introduction vers l'intérieur de celle-ci d'au moins un faisceau laser, ledit faisceau laser étant émis par ledit au moins un dispositif de génération de faisceau laser ;

une unité de transport de cible (2) prévue sur la chambre (1) et transportant un matériau cible vers une zone définie de la chambre (1) ;

un système optique de focalisation laser (15a, 15b) prévu pour focaliser ledit au moins un faisceau laser dans la zone définie ; et

un élément optique (31) prévu pour corriger la répartition d'intensité lumineuse d'une section de faisceau dudit au moins un faisceau laser dans la zone définie,

l'élément optique (31) étant prévu pour corriger la répartition d'intensité lumineuse de telle manière que,

dans la zone définie, la répartition d'intensité lumineuse de la section de faisceau dudit au moins un faisceau laser présente une uniformité définie dans la zone définie de la section de faisceau, ledit au moins un faisceau laser présentant une uniformité définie si la valeur de variation C ci-dessous est égale ou inférieure à 20 (%) ;

$$C = \{ (Imax-Imin) / (Imax+Imin) \} \times 100 \ (\%),$$

Imax : intensité lumineuse maximale dans une zone définie dans la section orthogonale à l'axe d'un faisceau laser,

Imin : intensité lumineuse minimale dans la zone définie dans la section orthogonale à l'axe d'un faisceau laser ;

**caractérisé**

**en ce qu'**une valeur minimale d'une dimension de la zone définie dans une direction orthogonale à la direction de déplacement du faisceau laser est égale ou supérieure à une valeur obtenue par ajout d'une plage de variation d'une position du matériau cible dans la zone définie à une valeur maximale d'une dimension dans la direction orthogonale.

2. Dispositif de chambre selon la revendication 1, où une surface de la zone définie est supérieure à une surface maximale dans une section du matériau cible dans la zone définie de la chambre (1), ladite section étant orthogonale à une direction de déplacement dudit au moins un faisceau laser.

3. Dispositif de chambre selon la revendication 1, où la différence entre intensité lumineuse minimale et intensité lumineuse maximale est égale ou inférieure à 20 % du total de l'intensité lumineuse minimale et de l'intensité lumineuse maximale dans la zone définie.

4. Dispositif de chambre selon la revendication 1, où le matériau cible transporté dans la chambre (1) est une gouttelette.

5. Dispositif de chambre selon la revendication 1, où le matériau cible comprend un métal.

6. Dispositif de chambre utilisé avec au moins un dispositif de génération de faisceau laser, comprenant :

une chambre (1) prévue avec au moins une ouverture d'incidence pour l'introduction vers l'intérieur de celle-ci d'au moins un faisceau laser, ledit faisceau laser étant émis par ledit au moins un dispositif de génération de faisceau laser ;
une unité de transport de cible (2) prévue sur la chambre (1) et transportant un matériau cible vers une zone définie de la chambre (1) ;
un système optique de focalisation laser (15a, 15b) prévu pour focaliser ledit au moins un faisceau laser dans la zone définie ; et
un élément optique (31) prévu pour corriger la répartition d'intensité lumineuse d'une section de faisceau dudit au moins un faisceau laser dans la zone définie, où ledit au moins un faisceau laser comprend un faisceau laser à pré-impulsion irradiant le matériau cible transporté dans la chambre (1), et un faisceau laser à impulsion principale irradiant le matériau cible irradié par le faisceau laser à pré-impulsion, et où
l'élément optique (31) est prévu pour corriger la répartition d'intensité lumineuse du faisceau laser à pré-impulsion, ledit faisceau laser à pré-impulsion présentant une uniformité définie si la valeur de variation C ci-dessous est égale ou inférieure à 20 (%) ;

$$C = \{ (Imax-Imin) \ / \ (Imax+Imin) \} \ x \ 100 \ (\%),$$

Imax : intensité lumineuse maximale dans une zone définie dans la section orthogonale à l'axe d'un faisceau laser à pré-impulsion,
Imin : intensité lumineuse minimale dans la zone définie dans la section orthogonale à l'axe d'un faisceau laser à pré-impulsion ;

**caractérisé**

**en ce qu'**une valeur minimale d'une dimension d'une section de faisceau du faisceau laser à impulsion principale dans la zone définie, est égale ou supérieure à une valeur obtenue par ajout d'une plage de variation d'une position du matériau cible irradié par le faisceau laser à pré-impulsion à une valeur maximale d'une dimension du matériau cible irradié par le faisceau laser à pré-impulsion dans une direction orthogonale à une direction de déplacement du faisceau laser à impulsion principale.

7. Dispositif de chambre selon la revendication 6, où une surface d'une section du faisceau laser à impulsion principale dans la zone définie est supérieure à une surface maximale du matériau cible irradié par le faisceau laser à pré-impulsion dans une section orthogonale à une direction de déplacement du faisceau laser à impulsion principale.

8. Dispositif de chambre selon la revendication 1, où ledit au moins un faisceau laser comprend un faisceau laser à pré-impulsion irradiant le matériau cible transporté dans la chambre (1), et un faisceau laser à impulsion principale irradiant le matériau cible irradié par le faisceau laser à pré-impulsion, et où
le faisceau laser à pré-impulsion et le faisceau laser à impulsion principale sont incidents à l'intérieur de la chambre (1) depuis des directions sensiblement identiques.

FIG. 1 A

FIG. 1 B

FIG. 1 C

**FIG. 2 A**

**FIG. 2 B**

**FIG. 2 C**

**FIG. 3 A**

BROKEN DROPLET

DL

ΔX

Dt

P

M

**FIG. 3 B**

LIGHT INTENSITY DISTRIBUTION
OF PRE-PULSE LASER BEAM

DL

Dt

Dd

M

P

BROKEN DROPLET

**FIG. 3 C**

DL

Dt

ΔX

P

M

BROKEN DROPLET

FIG. 4 A

DL (DIAMETER Dd)

RANGE IN WHICH
POSITION OF DROPLET
VARIES (Dd+2ΔX)

EVEN RANGE OF PRE-PULSE
LASER BEAM P (DIAMETER Dt)

FIG. 4 B

RANGE IN WHICH POSITION
OF DIFFUSED TARGET
VARIES (De+2ΔX)

DIFFUSED TARGET
(DIAMETER De)

M
(BEAM DIAMTETER Dm)

**FIG. 5**

| ΔX | PROBABILITY THAT DROPLET IS NOT IRRADIATED WITH EVEN REGION |
|---|---|
| 1σ | $1.59 \times 10^{-1}$ |
| 2σ | $2.28 \times 10^{-2}$ |
| 3σ | $1.35 \times 10^{-3}$ |
| 4σ | $3.17 \times 10^{-5}$ |
| 5σ | $2.87 \times 10^{-7}$ |
| 6σ | $9.87 \times 10^{-10}$ |
| 7σ | $1.28 \times 10^{-12}$ |
| 8σ | $6.22 \times 10^{-16}$ |
| 9σ | $1.13 \times 10^{-19}$ |
| 10σ | $7.62 \times 10^{-24}$ |

**FIG. 6**

RANGE IN WHICH POSITION OF DROPLET VARIES (Ydmax or Xdmax)

EVEN RANGE OF PRE-PULSE LASER BEAM P (DIAMETER FR)

FR

(FR–TR)

Ydmax

TR

Xdmax

**FIG. 7 A**

LIGHT INTENSITY DISTRIBUTION
OF PRE-PULSE LASER BEAM

**FIG. 7 B**

LIGHT INTENSITY DISTRIBUTION
OF PRE-PULSE LASER BEAM

**FIG. 7 C**

LIGHT INTENSITY DISTRIBUTION
OF PRE-PULSE LASER BEAM

**FIG. 8**

**FIG. 9**

**FIG. 10**

LIGHT INTENSITY DISTRIBUTION
OF PRE-PULSE LASER BEAM

**FIG. 11**

LIGHT INTENSITY DISTRIBUTION
OF PRE-PULSE LASER BEAM

**FIG. 12**

LIGHT INTENSITY DISTRIBUTION
OF PRE-PULSE LASER BEAM

**FIG. 13**

LIGHT INTENSITY DISTRIBUTION
OF PRE-PULSE LASER BEAM

**FIG. 14**

**FIG. 15 A**

**FIG. 15 B**

**FIG. 16**

**FIG. 17 A**

**FIG. 17 B**

**FIG. 18**

**FIG. 19 A**

LASER ABLATION REGION

Z DIRECTION

P

SHOCK WAVE

DL

**FIG. 19 B**

LIGHT INTENSITY DISTRIBUTION OF MAIN-PULSE LASER BEAM

Z DIRECTION

M

TORUS-SHAPED DIFFUSED TARGET

**FIG. 19 C**

RANGE IN WHICH POSITION
OF DIFFUSED TARGET
VARIES (Dout+2 ΔX)

TORUS-SHAPED
DIFFUSED TARGET
(OUTER DIAMETER Dout)

M
(BEAM DIAMTETER Dtop)

**FIG. 20**

**FIG. 21**

**FIG. 22**

|  | CASE 1 | CASE 2 | CASE 3 | CASE 4 |
|---|---|---|---|---|
| BEAM SHAPE | TOP HAT | TOP HAT | TOP HAT | TOP HAT |
| E (mJ) | 0.3 | 0.3 | 0.3 | 0.5 |
| T (ns) | 20 | 10 | 0.1 | 0.05 |
| Dt (μm) | 30 | 30 | 30 | 30 |
| W (W/cm²) | $2.12 \times 10^9$ | $4.24 \times 10^9$ | $4.24 \times 10^{11}$ | $1.41 \times 10^{12}$ |

**FIG. 23**

**FIG. 24**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1589792 A2
- WO 2005025280 A2
- US 2006215712 A1